# EUROPEAN PATENT SPECIFICATION

(11) **EP 2 006 323 B1**
(45) Date of publication and mention of the grant of the patent: **18.11.2009**
(21) Application number: 08010437.5
(22) Date of filing: 09.06.2008
(51) Int. Cl.: C08K 3/34, C08J 5/00

(54) **Process for the production of polyester nanocomposites**
Verfahren zur Herstellung von Polyesternanokompositen
Procédé de production de nano-composites de polyester

(30) Priority: 22.06.2007 US 767035
(43) Date of publication of application: 24.12.2008
(73) Proprietor: E.I. DU PONT DE NEMOURS AND COMPANY, Wilmington, DE 19898 (US)
(72) Inventor: Molitor, Michael Joseph, Wilmington Delaware 19804 (US); Weiberg, Mark Gary, Wilmington Delaware 19810 (US); Wetzel, Mark David, Newark Delaware 19711 (US); Williamson, David T., Virginia 23238 (US)
(74) Representative: Matthews, Derek Peter

(56) References cited:
- WO-A-2006/069128
- WO-A-2006/069131
- US-A1- 2006 157 350

## Description

### FIELD OF THE INVENTION

The present Invention relates to methods of forming polyester nanocomposites comprising a sepiolite-type clay nanofiller and a polyester.

### BACKGROUND OF THE INVENTION

Nanocomposites are polymers reinforced with nanometer sized particles, i.e., particles with a dimension on the order of 1 to several hundred nanometers.

Polymer-layered silicate nanocomposites incorporate a layered clay mineral filler in a polymer matrix. Layered silicates are made up of several hundred thin platelet layers stacked into an orderly packet known as a tactoid. Each of these platelets is characterized by a large aspect ratio (diameter/thickness on the order of 100-1000). Accordingly, when the clay is dispersed homogeneously and exfoliated as individual platelets throughout the polymer matrix, dramatic increases in strength, flexural and Young's modulus, and heat distortion temperature are observed at very low filler loadings (<10% by weight) because of the large surface area contact between polymer and filler. In addition, barrier properties are greatly improved because the large surface area of the platelets greatly increases the tortuosity of the path a diffusing species must follow in permeating through the polymeric material.

U. S. Patent Application Publication 20060004135 discloses a process for preparing a dispersion of filler particles in a polymer or polymerizable material, comprising a) forming a masterbatch of filler particles dispersed in a macrocyclic oligomer, wherein the masterbatch contains at least 10 weight percent of dispersed filler particles, and b) mixing the masterbatch with a polymer or polymerizable material to form a dispersion of the filler particles in a mixture of the macrocyclic oligomer and the polymer or polymerizable material, wherein the filler particles have a volume average smallest dimension of about 0.6 nanometer to about 50 nanometers. In an embodiment, a masterbatch is formed by mixing the filler particles with the macrocyclic oligomer and then solid state polymerizing the macrocyclic oligomer. The macrocyclic polyester oligomer needs to be synthesized, adding cost to the process.

PCT Patent Application WO 2000/034377 discloses a process for preparing an exfoliated, high I. V. polymer-platelet nanocomposite comprising the steps of: (i) melt mixing platelet particles with a matrix polymer-compatible oligomeric resin to form an oligomeric resin-platelet particle composite; and (ii) mixing the oligomeric resin-platelet particle composite with a high molecular weight matrix polymer, thereby increasing the molecular weight of the oligomeric resin-platelet particle composite and producing an exfoliated, high I. V. polymer nanocomposite material. Suitable platelet particles are less than about 2 nm thick, about 10 to about 5000 nm in diameter, have a cation exchange capacity from about 30 to about 300 meq/100 g, and are preferably treated to enhance separation of agglomerates into platelets, e.g., by intercalation with one or more of: polymers, organic reagents or monomers, silane compounds, metals or organometallics, and organic cations.

PCT Patent Application WO 2006/069128 discloses a process for manufacturing polyester/clay nanocomposites comprising mixing a sepiolite-type clay with at least one linear polyester oligomer and subsequently polymerizing the at least one linear polyester oligomer. On a large manufacturing scale, the high viscosity of mixtures with large amounts of sepiolite-type clays makes them difficult to process effectively.

For the reasons set forth above, there exists a need for an improved process for producing polyester-containing nanocomposite materials.

### SUMMARY OF THE INVENTION

The invention is directed a method for dispersing particles of sepiolite-type clay in a polyester matrix comprising melt-mixing a mixture of:
a. sepiolite-type clay,
b. at least one linear polyester oligomer, and
c. at least one polyester polymer
to produce a nanocomposite composition; and, optionally, subjecting said nanocomposite composition to solid state polymerization to increase polyester molecular weight.

The invention is further directed to a method for preparing a polyester nanocomposite composition from a masterbatch, comprising melt-compounding a mixture of: sepiolite-type clay, at least one polyester oligomer, and at least one polyester polymer to produce a nanocomposite composition containing a greater concentration of sepiolite-type clay than is desired in the final resin composition; optionally, subjecting said nanocomposite composition to solid state polymerization to increase the polyester molecular weight; and further melt compounding said nanocomposite composition with polyester polymer and, optionally, additional ingredients.

### BRIEF DESCRIPTION OF THE DRAWINGS

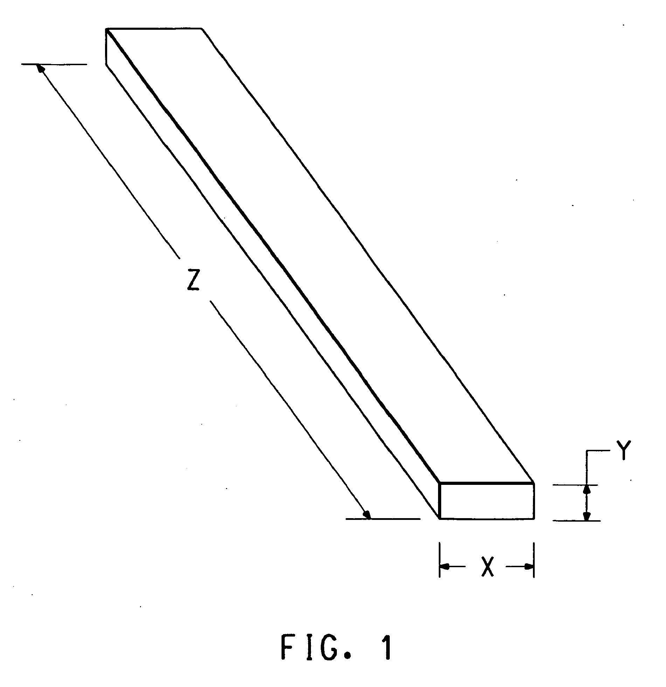

Figure 1 is a schematic diagram of the dimensions of a sepiolite-type clay fiber.

### DETAILED DESCRIPTION OF THE INVENTION

In the context of this disclosure, a number of terms shall be utilized.

As used herein, the term "nanocomposite" or "polymer nanocomposite" means a polymeric material which contains particles, dispersed throughout the polymeric material, having at least one dimension in the 0.1 to 100 nm range ("nanoparticles"). The polymeric material in which the nanoparticles are dispersed is often referred to as the "polymer matrix." The term "polyester composite" refers to a nanocomposite in which the polymeric material includes at least one polyester.

As used herein, the term "sepiolite-type clay" refers to both sepiolite and attapulgite (palygorskite) clays.

The term "exfoliate" literally refers to casting off in scales, laminae, or splinters, or to spread or extend by or as if by opening out leaves. In the case of smectic clays, "exfoliation" refers to the separation of platelets from the smectic clay and dispersion of these platelets throughout the polymer matrix. As used herein, for sepiolite-type clays, which are fibrous in nature, "exfoliation" or "exfoliated" means the separation of fiber bundles or aggregates into nanometer diameter fibers which are then dispersed throughout the polymer matrix.

As used herein, "polyester" means a condensation polymer in which more than 50 percent of the groups connecting repeat units are ester groups. Thus polyesters may include polyesters, poly(ester-amides) and poly(ester-imides), so long as more than half of the connecting groups are ester groups. Preferably at least 70% of the connecting groups are esters, more preferably at least 90% of the connecting groups are ester, and especially preferably essentially all of the connecting groups are esters. The proportion of ester connecting groups can be estimated to a first approximation by the molar ratios of monomers used to make the polyester.

As used herein, "PET" means a polyester in which at least 80, more preferably at least 90, mole percent of the diol repeat units are from ethylene glycol and at least 80, more preferably at least 90, mole percent of the dicarboxylic acid repeat units are from terephthalic acid.

As used herein, "oligomer" means a molecule that contains 2 or more identifiable structural repeat units of the same or different formula.

As used herein, "linear polyester oligomer" means oligomeric material, excluding macrocyclic polyester oligomers, which by itself or in the presence of monomers can polymerize to a higher molecular weight polyester.

As used herein, "polyester component" refers to the total of all polyester moieties present in the nanocomposite, i.e., linear oligomers plus polymer(s).

As used herein, "resin" means a composition comprising a polymer and at least one additional ingredient (for example, a filler, flame retardant, toughener, plasticizer, etc.).

As used herein, the term "melt mixing" means applying shear stress to a melt to mix the ingredients comprising the melt. One or more ingredients (e.g., clay, glass fiber) may remain unmelted during the melt mixing process as long as at least one ingredient is molten. The terms "melt mixing," "compounding," and "melt compounding" as used herein are synonymous.

As used herein, the term "dry blend" means to mix together unmelted ingredients, typically prior to melt mixing.

As used herein, the term "staged feeding" indicates that ingredients are separately fed at different stages of a melt mixing process. For example, two different ingredients may be fed into one feed port of an extruder and a third ingredient into a second feed port downstream of the first one.

As used herein, the term "split feeding" indicates that the total amount of an ingredient has been split into two or more portions and the portions are separately fed at different stages of a melt mixing process. For example, an ingredient may be split into three portions, each of which is fed into a different feed port of an extruder.Where a range of numerical values is recited herein, unless otherwise stated, the range is intended to include the endpoints thereof, and all integers and fractions within the range. It is not intended that the scope of the invention be limited to the specific values recited when defining a range.

One aspect of the invention described herein is directed to a method for dispersing sepiolite-type clay particles in a polyester matrix comprising melt-compounding a mixture of: sepiolite-type clay, at least one polyester oligomer, and at least one polyester polymer to produce a nanocomposite composition; and, optionally, subjecting said nanocomposite composition to solid state polymerization to increase the polyester molecular weight.

Another aspect of the invention described herein is a method for preparing a polyester nanocomposite composition from a masterbatch, comprising melt-compounding a mixture of: sepiolite-type clay, at least one polyester oligomer, and at least one polyester polymer to produce a nanocomposite composition containing a greater concentration of sepiolite-type clay than is desired in the final resin composition; optionally, subjecting said nanocomposite composition to solid state polymerization to increase the polyester molecular weight; and further melt compounding said nanocomposite composition with polyester polymer and, optionally, additional ingredients.

A further aspect of the invention described herein is a composition comprising a mixture of: exfoliated sepiolite-type clay, at least one polyester oligomer, and at least one high molecular weight polyester.

### Preparing the Polyester Nanocomposite

The nanocomposite composition contains about 0.1 to about 35 wt% of sepiolite-type clay

### Sepiolite and Attapulgite

Sepiolite [Mg₄Si₆O₁₅(OH)₂·6(H₂O)] is a hydrated magnesium silicate filler that exhibits a high aspect ratio due to its fibrous structure. Unique among the silicates, sepiolite is composed of long lath-like crystallites in which the silica chains run parallel to the axis of the fiber. The material has been shown to consist of two forms, an α and a β form. The α form is known to be long bundles of fibers and the β form is present as amorphous aggregates.

Attapulgite (also known as palygorskite) is almost structurally and chemically identical to sepiolite except that attapulgite has a slightly smaller unit cell. As used herein, the term "sepiolite-type clay" includes attapulgite as well as sepiolite itself.

Sepiolite-type clays are layered fibrous materials in which each layer is made up of two sheets of tetrahedral silica units bonded to a central sheet of octahedral units containing magnesium ions (see, e.g., Figures 1 and 2 in L. Bokobza et al., Polymer International, 53, 1060-1065 (2004)). The fibers stick together to form fiber bundles, which in turn can form agglomerates. These agglomerates can be broken apart by industrial processes such as micronization or chemical modification (see, e.g., European Patent 170,299 to Tolsa, S.A.) to produce nanometer diameter fibers, i.e., exfoliated sepiolite-type clay.

The amount of sepiolite-type clay used in the present invention ranges from about 0.1 to about 35 wt% based on the final composite composition. The specific amount chosen will depend on the intended use of the nanocomposite, as is well understood in the art.

Sepiolite-type clays are available in a high purity ("rheological grade"), uncoated form (e.g., PANGEL® S9 sepiolite clay from the Tolsa Group, Madrid, Spain) or, more commonly, treated with an organic material to make the clay more "organophilic," i.e., more compatible with systems of low-to-medium polarity (e.g., PANGEL® B20 sepiolite clay from the Tolsa Group). An example of such a coating for sepiolite-type clay is a quaternary ammonium salt such as dimethylbenxylalkylammonium chloride, as disclosed in European Patent Application 221,225.

The sepiolite-type clay used in the process described herein is typically unmodified; i.e., the surface of the sepiolite-type clay has not been treated with an organic compound (such as an onium compound, for example, to make its surface less polar). Such onium compounds tend to degrade at the temperatures used to process polyesters such as PET.

In an embodiment, the sepiolite-type clay is rheological grade, such as described in European patent applications EP-A-0454222 and EP-A-0170299 and marketed under the trademark Pangel® by Tolsa, S.A., Madrid, Spain. As described therein "rheological grade" denotes a sepiolite-type clay with a specific surface area greater than 120 m²/g (N₂, BET), and typical fiber dimensions: 200 to 2000 nm long, 10-30 nm wide, and 5-10 nm thick. The width (x) and thickness (y) and length (z) of a typical sepiolite-type clay fiber contained in the compositions described herein is illustrated in Figure 1.

Rheological grade sepiolite is obtained from natural sepiolite by means of special micronization processes that substantially prevent breakage of the sepiolite fibers, such that the sepiolite disperses easily in water and other polar liquids, and has an external surface with a high degree of irregularity, a high specific surface, greater than 300 m²/g and a high density of active centers for adsorption, that provide it a very high water retaining capacity upon being capable of forming, with relative ease, hydrogen bridges with the active centers. The microfibrous nature of the rheological grade sepiolite nanoparticles makes sepiolite a material with high porosity and low apparent density.

Additionally, rheological grade sepiolite has a very low cationic exchange capacity (10-20 meq/100 g) and the interaction with electrolytes is very weak, which in turn causes rheological grade sepiolite not to be practically affected by the presence of salts in the medium in which it is found, and therefore, it remains stable in a broad pH range.

The above-mentioned qualities of rheological grade sepiolite can also be attributed to rheological grade attapulgite with particle sizes smaller than 40 microns, such as for example the range of ATTAGEL goods (for example ATTAGEL 40 and ATTAGEL 50) manufactured and marketed by the firm Engelhard Corporation, United States, and the MIN-U-GEL range of Floridin Company.

Typically, the amount of sepiolite-type clay used in the present invention ranges from about 0.1 to about 35 wt% based on the total amount of sepiolite-type clay and polyester in the nanocomposite composition. The specific amount chosen will depend on the intended use of the nanocomposite composition, as is well understood in the art. For example, in film, it may be advantageous to use as little sepiolite-type clay as possible, so as to retain desired optical properties.

The method described herein is particularly useful in preparing "masterbatches" of the nanocomposite composition, which contain relatively high concentrations of sepiolite-type clay, typically 15 to 30 wt%. The masterbatch can then be mixed with additional polyester (let down), and optionally other ingredients to produce a resin composition that contains a desired lower concentration of sepiolite-type clay. Let-down ratios are selected so that the desired level of dispersed filler particles is present in the final product. For example, a nanocomposite composition masterbatch containing 30% by weight of the sepiolite-type clay may be used. Then, if a composition having 3 weight percent of the sepiolite-type clay is needed, the composition containing the 3 weight percent may be made by melt mixing 1 part by weight of the 30% masterbatch with 9 parts by weight of the "pure" polyester, i.e., a let-down ratio of 9 parts additional polymer to 1 part masterbatch. A let-down weight ratio of from about 0.5-20 parts of additional polymer or polymerizable material to 1 part masterbatch, especially about 1-10:1 or even about 2-6:1 is often convenient. This is conveniently done by melting the components and mixing them, or by forming a dry blend followed by heating and melt mixing. During melt mixing, other ingredients can also be added to form a final desired composition.

The amount of sepiolite-type clay in the nanocomposite is typically about 0.1 to about 35 wt% based on the weight of sepiolite-type clay plus polyester component. The polyester component itself is about 1 to about 99 wt% linear oligomer and about 99 to about 1 wt% polyester polymer.

### Polyesters

The linear polyester oligomer and the polyester polymer used in the process described herein may be any polyester with the requisite melting point. Typically, the melting point of both the polyester polymer that is a mixture component and the polyester polymer that has the same repeat units as the linear polyester oligomer is about 150°C or higher, and more preferably about 200°C or higher.

The molecular weight of the polyester polymer will depend on the eventual use of the final composition. Typically, the number average molecular weight (Mₙ) will be from about 12,000 to about 50,000.

Linear polyester oligomers include, for example, oligomers of linear polyesters and oligomers of polymerizable polyester monomers. For example, reaction of dimethyl terephthalate or terephthalic acid with ethylene glycol, when carried out to remove methyl ester or carboxylic groups, usually yields a mixture of bis(2-hydroxyethyl) terephthalate and a variety of oligomers: oligomers of bis(2-hydroxyethyl) terephthalate, oligomers of mono(2-hydroxyethyl) terephthalate (which contain carboxyl groups), and polyester oligomers capable of being further extended. Typically, such oligomers will have an average degree of polymerization (average number of monomer units) of about 20 or less, more typically about 10 or less. The linear polyester oligomers may be obtained as a byproduct of a polyester polymer manufacturing process (see, e.g., S. Hansen and K. B. Atwood, "Polyester Fibers," Kirk-Othmer Encyclopedia of Chemical Technology, John Wiley & Sons, A. Seidel ed., 5th edition, vol. 20, 1-31 (2006)). Alternatively, they may be produced by degrading ("cracking") polyester polymer, for example, by alcoholysis as described by David E. Nikles, Medhat S. Farahat in "New Motivation for the Depolymerization Products Derived from Poly(Ethylene Terephthalate) (PET) Waste: a Review" (Macromolecular. Materials and Engineering, 290, 13-30 (2005)) or by glycolysis (see, e.g., "Kinetics of glycolysis of poly(ethylene terephthalate) melts," J. R. Campanelli, M. R. Kamal, and D. G. Cooper, Journal of Applied Polymer Science, 54(11), 1731-40, (1994).)

Linear polyester oligomers obtained by these processes are likely to have a broad molecular weight distribution and to contain measurable amounts of monomeric species. Linear polyester oligomer could also be produced *in situ* in the process described herein by adding monomeric species (e.g., ethylene glycol, bis-hydroxyterephthalic acid) to a mixture of polyester polymer and sepiolite-type clay and then melt mixing.

Polyesters (which have mostly or all ester linking groups) are normally derived from one or more dicarboxylic acids and one or more diols. They can also be produced from polymerizable polyester monomers or from macrocyclic or linear polyester oligomers as described in copending U. S. Patent Application 11/312068 herein incorporated by reference in its entirety.

Polyesters for use in practicing the invention described herein may be amorphous, crystalline, semicrystalline, anisotropic (i.e., liquid crystalline), or isotropic or may contain a mixture of these morphologies. Polyesters most suitable for use in practicing the invention comprise isotropic thermoplastic polyester homopolymers and copolymers (both block and random).

The production of polyesters from reaction mixtures containing diols and hydrocarbyl diacids or esters of such diacids is well known in the art, as described by A. J. East, M. Golden, and S. Makhija in the Kirk-Othmer Encyclopedia of Chemical Technology, John Wiley & Sons, J. I. Kroschwitz exec. ed., M. Howe-Grant, ed., 4th edition (1996), vol. 19, 609-653. Among suitable diacids (and their corresponding esters) are those selected from the group consisting of terephthalic acid, isophthalic acid, naphthalene dicarboxylic acids, cyclohexane dicarboxylic acids, succinic acid, glutaric acid, adipic acid, sebacic acid, 1,12-dodecane dioic acid fumaric acid, maleic acid, and the derivatives thereof, such as, for example, the dimethyl, diethyl, or dipropyl.esters.

Some representative examples of glycols that can be utilized as the diol component include ethylene glycol, 1,3-propylene glycol, 1,2-propylene glycol, 2,2-diethyl-1,3-propane diol, 2,2-dimethyl-1,3-propane diol, 2-ethyl-2-butyl-1,3-propane diol, 2-ethyl-2-isobutyl-1,3-propane diol, 1,3-butane diol, 1,4-butane diol, 1,5-pentane diol, 1,6-hexane diol, 2,2,4-trimethyl-1,6-hexane diol, 1,2-cyclohexane dimethanol, 1,3-cyclohexane dimethanol, 1,4-cyclohexane dimethanol, 2,2,4,4-tetramethyl-1,3-cyclobutane diol, isosorbide, naphthalene glycols, biphenols, diethylene glycol, triethylene glycol, resorcinol, hydroquinone, t-butyl-hydroquinone, and longer chain diols and polyols, such as polytetramethylene ether glycol, which are the reaction products of diols or polyols with alkylene oxides. Alkyl-substituted and chloro-substituted versions of these species may also be used.

Polyesters suitable for use in the present invention can also be produced directly from reaction mixtures containing polymerizable polyester monomers. Some representative examples of said polymerizable polyester monomers hydroxyacids such as hydroxybenzoic acids, hydroxynaphthoic acids and lactic acid; bis(2-hydroxyethyl) terephthalate, bis(4-hydroxybutyl) terephthalate, bis(2-hydroxyethyl)naphthalenedioate, bis(2-hydroxyethyl)isophthalate, bis[2-(2-hydroxyethoxy)ethyl]terephthalate, bis[2-(2-hydroxyethoxy)ethyl]isophthalate, bis[(4-hydroxymethylcyclohexyl)methyl]terephthalate, and bis[(4-hydroxymethylcyclohexyl)methyl]isophthalate, mono(2-hydroxyethyl)terephthalate, bis(2-hydroxyethyl)sulfoisophthalate, and lactide. Alkyl-substituted and chloro-substituted versions of these species may also be used.

Polyester polymers can also be produced directly from reaction mixtures containing macrocyclic polyester oligomers. Examples of suitable macrocyclic polyester oligomers include without limitation macrocyclic polyester oligomers of 1,4-butylene terephthalate (CBT); 1,3-propylene terephthalate (CPT); 1,4-cyclohexylenedimethylene terephthalate (CCT); ethylene terephthalate (CET); 1,2-ethylene 2,6-naphthalenedicarboxylate (CEN); the cyclic ester dimer of terephthalic acid and diethylene glycol (CPEOT); and macrocyclic co-oligoesters comprising two or more of the above structural repeat units. Alkyl-substituted and chloro-substituted versions of these species may also be used.

The polyesters may be branched or unbranched, and may be homopolymers or copolymers or polymeric blends comprising at least one such homopolymer or copolymer.

Examples of specific polyesters include without limitation poly(ethylene terephthalate) (PET), poly(1,3-propylene terephthalate) (PPT), poly(1,4-butylene terephthalate) (PBT), a thermoplastic elastomeric polyester having poly(1,4-butylene terephthalate) and poly(tetramethylene ether)glycol blocks (available as HYTREL® from E. I. du Pont de Nemours & Co., Inc., Wilmington, DE 19898 USA), poly(1,4-cylohexyldimethylene terephthalate) (PCT), and polylactic acid (PLA).

### Melt-mixing Process Conditions

In the process described herein, a mixture is formed comprising sepiolite-type clay, at least one linear polyester oligomer, and at least one polyester polymer. The mixture is melt-mixed (i.e., a shear stress is applied to the molten mixture) and, optionally, subjected to solid phase polymerization to raise the polyester molecular weight. Process equipment typical for melt-mixing thermoplastics in a batchwise or continuous fashion may be used. Examples of such equipment include without limitation kneaders (e.g., a Buss Co-Kneader from Buss AG, Pratteln, Switzerland), extruders (single screw, twin-screw, multi-screw), Banbury® Mixers, Farrel® Continuous Mixers (Banbury® and Farrel® are registered trademarks of Farrel Corporation, Ansonia, Connecticut, USA), and the like. Twin-screw extruders, such as ZSK machines from Werner & Pfleiderer (now part of Coperion Werner & Pfleiderer GmbH & Co. KG, Stuttgart, Germany) are commonly used. For processing using a twin-screw extruder, the screw design encompasses the typical polyester processing operations of conveying, melting, mixing, homogenization, dispersion, devolatilization (i.e., off-gassing), stranding, and pelletization. The optimum mixing intensity depends on the configuration of the mixer, the temperatures, compositions, etc. being mixed, and is readily determined by one skilled in the art.

It is difficult to melt mix, especially on a large scale, a low viscosity material (molten linear oligomer), a high viscosity material (molten polymer), and an ultrafine powder (sepiolite-type clay, especially of rheological grade) and achieve good dispersion of the clay particles, to produce a material that can be used to make articles with good mechanical properties. The ingredients of the nanocomposite may be introduced to an extruder in a number of different ways. We have found that, while it is possible to feed a mixture of the ingredients at once, staged feeding and/or split feeding the ingredients facilitates the production of well-mixed nanocomposite material. In some embodiments, separate ingredients may be fed into separate feed ports (staged feeding; for example, one ingredient fed into one port, two other ingredients into a second). In other embodiments, feeds of any single component (linear polyester oligomer, polyester polymer, sepiolite-type clay, optional ingredients) may be split into two or more streams and fed into multiple feed ports (split feeding). In yet other embodiments, both staged feeding and split feeding processes are used. Examples include but are not limited to the following, wherein ingredients are added at once in processes a, b, c, and f; d, e, g, and h are examples of processes with staged feeding; i is an example of split feeding; and j is an example of mixed staged feeding and split feeding:
a. dry blend solid linear polyester oligomer, polyester polymer, and sepiolite-type clay and extrude the mixture, introducing the mixture into one port;
b dry blend solid linear polyester oligomer and sepiolite-type clay separately and introduce this blend, together with polyester polymer, into one port;
c. feed solid or molten polyester polymer, solid or molten linear polyester oligomer, and sepiolite-type clay into one feed port;
d. feed solid or molten polyester polymer into a first feed port, feed solid or molten linear polyester oligomer into a second feed port downstream ,and then sepiolite-type clay into a third feed port further downstream;
e. feed solid or molten polyester polymer into a first feed port and then feed a blend of solid or molten linear polyester oligomer with sepiolite-type clay into a second feed port downstream;
f. feed solid or molten polyester polymer and solid or molten linear polyester oligomer into one feed port along with either dry sepiolite-type clay or sepiolite-type clay in a slurry with some additional, liquid ingredient, e.g., a plasticizer.
g. feed the solid or molten polyester polymer into a first feed port, feed molten linear polyester oligomer into a second feed port downstream, then feed sepiolite-type clay in a slurry with an additional, liquid ingredient, e.g., a plasticizer, into a third feed port further downstream;
h. feed the solid or molten polyester polymer into a first feed port, sepiolite-type clay into a second feed port downstream, and then solid or molten linear polyester oligomer into a third feed port further downstream;
i. feed the solid or molten polyester polymer into a first feed port, feed a portion of the molten linear oligomer plus a portion of the sepiolite-type clay into a second feed port downstream, and feed the remainder of the molten linear oligomer plus the remainder of the sepiolite-type clay into a third feed port further downstream; and
j. feed the solid or molten polyester polymer, solid or molten linear polyester oligomer, and a portion of the sepiolite-type clay into a first feed port and feed the rest of the sepiolite-type into a second feed port downstream.

In another embodiment, two or more extruders in series can be employed, each to perform one or more compounding steps. Alternatively, some or all of the output of an extruder can be re-fed one or more times through the same extruder to produce the final composition.

Extrusion conditions are adjusted depending on the specific composition, i.e., specific materials and relative amounts. For example, extrusion temperatures may need to be adjusted to maintain adequate melt strength depending on the concentration of linear polyester oligomer and whether the oligomer is solid or molten when added. Such considerations are well-understood by a practitioner of the art and can readily be adapted for different compositions.

The molecular weight of the polymer material in the resulting nanocomposite may be increased by any of a number of known approaches, or by a combination of any of these approaches, e.g., chain extension, reactive extrusion, extrusion let-down, solid state polymerization or annealing, annealing under a flow of inert gas, vacuum annealing, let-down in a melt reactor, etc. The productivity of such processes for increasing molecular weight is enhanced by the presence of the end groups on the linear polyester oligomer. Solid state polymerization ("SSP," also referred to as "solid phase polymerization") is typically used (see, e.g., A. East, "Polyesters, Thermoplastic," Kirk-Othmer Encyclopedia of Chemical Technology, John Wiley & Sons, A. Seidel ed., 5th edition, vol. 20, 31-95 (2006)).

### Optional ingredients to be melt-mixed with the nanocomposite composition

Nanocomposites may contain additional ingredients, including but not limited to stabilizers, antioxidants, tougheners, pigments, other fillers, plasticizers, lubricants, mold release agents, flame retardants, other polymers.

Nanocomposite compositions containing ingredients in addition to polyester and sepiolite-type clay can be prepared in a variety of ways. A polyester nanocomposite masterbatch with a high concentration of sepiolite-type clay could be prepared using the process described herein, then let down by melt mixing with additional polyester, then melt mixed with the desired added ingredients (process A). Alternatively, and more economically, the masterbatch could simply be melt-mixed with the additional polyester and desired additional ingredients at once (process B). In another variation (process C), a polyester nanocomposite could be prepared at the desired final sepiolite-type clay concentration and melt-mixed in a separate step with the desired additional ingredients, or (process D) the final composition could be prepared by including all ingredients when the nanocomposite is made. Other variations might combine these approaches; for example, a stabilizer might be included when a nanocomposite masterbatch is prepared and flame retardant added when the masterbatch is let down with additional polyester. Which of these or other processes is used will depend on factors such as economics and the nature of the additional ingredients and is readily determined by one of ordinary skill in the art. For example, process B is more economical than process A because it has two processing steps while A has three. Process D may be convenient in some circumstances, for example, when the additional ingredients are relatively volatile or thermally of borderline stability. Process C allows the manufacturer some flexibility in composition formulation, while use of a masterbatch in process A or B is more flexible by allowing easy variation of clay content over a wide range.

If deemed appropriate, ingredients may be added at one or more downstream points in the extruder instead of into a rear feed port for one or more of a variety of reasons, for example, to decrease attrition of solids such as fillers, improve dispersion, decrease equipment wear, decrease the thermal history of relatively thermally unstable ingredients, and/or decrease losses by evaporation of volatile ingredients.

### Solid particulate fillers exclusive of the sepiolite-type clay

Other solid fillers can be added during the extrusion of the sepiolite-type clay/linear polyester oligomer/polyester polymer mixture or melt mixed with a formed nanocomposite composition in a separate step.

Such fillers must be finely divided enough to be dispersed under melt mixing conditions into the composition. Typically, the solid particulate filler will be a material which may already be used in thermoplastic compositions, such as pigments, reinforcing agents, and fillers. The solid particulate filler may or may not have a coating on it, for example, a sizing and/or a coating to improve adhesion of the solid particulate filler to the polymers of the composition. The solid particulate filler may be organic or inorganic. Useful solid particulate fillers include minerals such as clay (other than sepiolite and attapulgite), talc, wollastonite, mica, and calcium carbonate; glass in various forms such as fibers, milled glass, solid or hollow spheres; carbon as carbon black, carbon fiber, graphene sheets (exfoliated graphite, graphite oxide), carbon nanotubes or nano-diamond; titanium dioxide; aramid in the form of short fibers, fibrils or fibrids; and flame retardants such as antimony oxide, sodium antimonate, and appropriate infusible organic compounds.

The solid particulate material may be conventionally melt mixed with the nanocomposite, for example in a twin-screw extruder or Buss kneader. However the particulate material may also be added to the process for forming the polyester nanocomposite, *i.e.,* added as part of the formation of the polymer/sepiolite-type clay/linear oligomer mixture. It may be added at the same time as the sepiolite-type clay, although if a great deal of particulate material is added it may increase the viscosity of the material undergoing the melt mixing process, and care should be taken not to increase the viscosity so much that the material is difficult to process.

### Plasticizers

Plasticizers can be added during the extrusion of the sepiolite-type clay/linear polyester oligomer/polyester polymer or melt mixed with a formed nanocomposite composition in a separate step.

A plasticizer is a compound that, when added to a polymer, makes it more pliable, typically by lowering its glass transition temperature. A plasticizer is typically a compound or mixture of compounds with a melting point of about 50°C or less with a(n) (average) molecular weight of 2000 or less. Typically, the plasticizer is 0 to about 5 weight percent of the weight of polyester in the composition. Specific useful plasticizers include poly(ethylene glycol 400) di-2-ethylhexanoate and poly(ethylene glycol) dilaurate with a number average molecular weight of approximately 946.

### Toughening Agents

Toughening agents can be added during the extrusion of the sepiolite-type clay/linear polyester oligomer/polyester polymer or melt mixed with a formed nanocomposite composition in a separate step.

Materials used to toughen polymers are well known. Two examples of the many references in this area are Polymer Blends - Volume 2: Performance, D. R. Paul and C. B. Bucknall, eds., John Wiley & Sons (2000) and Rubber-toughened Plastics (Advances in Chemistry Series No. 222), C. K. Riew (ed.), American Chemical Society (1989).

One optional ingredient in the compositions of the present invention is a polymeric toughening agent. This is a polymer, typically which is an elastomer or has a relatively low melting point, generally <200°C, preferably <150°C, which has attached to it functional groups which can react with the polyester (and optionally other polymers present), as described in copending U. S. Patent Application 11/312065, herein incorporated by reference in its entirety. Typically the amount of polymeric toughening agent containing functional groups present is about 1 to about 20 percent based on the weight of the polyester. Examples of suitable tougheners include those listed in U.S. Patent 4,753,980, which is hereby incorporated by reference, such as copolymers of ethylene, ethyl acrylate or n-butyl acrylate, and glycidyl methacrylate.

The polymeric toughener typically will contain about 0.5 to about 20 weight percent of monomers containing functional groups, often about 1.0 to about 15 weight percent, or even about 7 to about 13 weight percent of monomers containing functional groups.

### Other polymers

Other polymers can be added during the extrusion of the sepiolite-type clay/linear polyester oligomer/polyester polymer or melt mixed with a formed nanocomposite composition in a separate step.

The polyester nanocomposites can be blended with a wide variety of other polymers, as described in copending U. S. Patent Application 11/642182, herein incorporated by reference in its entirety. Such other polymers include olefin homopolymers and copolymers, thermoplastic polyurethanes, polyvinyl chloride, polyvinylidene chloride copolymers, liquid crystalline polymers, fluorinated polymers, polyamides, polyimides, polyphenylene sulfide, polyphenylene oxide, polysulfones, polyethersulfones, rubbers, polycarbonate, polyacrylates, terpene resins, polyacetal, styrene-containing copolymers, coumarone/indene copolymers, and the like and combinations thereof.

### Epoxy compounds or resins

Another type of other ingredient is an epoxy compound or resin. It is believed that in some instances the epoxy compound or resin stabilizes melt viscosity and/or improves color stability of the composition. Typically such a compound or resin has an average molecular weight of less than about 1000. This epoxy material is normally present at a level of 0 to about 1.0 weight percent of the entire composition. It can be added during the extrusion of the sepiolite-type clay/linear polyester oligomer/polyester polymer or melt mixed with a formed nanocomposite composition in a separate step.

Examples of useful epoxy compounds or resins include without limitation Epon® 1002F, 1009F or 1031 (Resolution Performance Products, Houston, Texas); and Araldite® GT7099 or GT6099 (Huntsman Advanced Materials Americas Inc., Los Angeles, California).

### Hydrolysis stabilizers

Hydrolysis stabilizers can be added during the extrusion of the sepiolite-type clay/linear polyester oligomer/polyester polymer or melt mixed with a formed nanocomposite composition in a separate step.

The polyester nanocomposites can be stabilized with an effective amount of any hydrolysis stabilization additive, particularly when it is to be used to form monofilament. The hydrolysis stabilization additive can be any known material that enhances the stability of the polyester nanocomposite to hydrolytic degradation. Examples of the hydrolysis stabilization additive can include: diazomethane, carbodiimides, epoxides, cyclic carbonates, oxazolines, aziridines, keteneimines, isocyanates, alkoxy end-capped polyalkylene glycols, and the like, as described in copending U. S. Patent Application 11/642182, herein incorporated by reference in its entirety.

In general, the amount of hydrolysis stabilization additive used is from 0.1 to 10.0 weight percent based on the polyester nanocomposite. Typically the amount of the hydrolysis stabilization additive used is in the range of 0.2 to 4.0 weight percent.

### Other Additives

Other ingredients can be added during the extrusion of the sepiolite-type clay/linear polyester oligomer/polyester polymer or melt mixed with a formed nanocomposite composition in a separate step. Such ingredients may be added to the present composition in amounts commonly used in thermoplastics as needed for the desired end use. Examples of such materials include without limitation antioxidants, lubricant, mold release agents, flame retardants, (paint) adhesion promoters, thermal stabilizers, UV absorbers, UV stabilizers, processing aids, waxes, color stabilizers, pigments, nucleants, dyes, delusterants such as titanium dioxide and zinc sulfide, antiblocks such as silica, antistats, brighteners, silicon nitride, metal ion sequestrants, anti-staining agents, silicone oil, surfactants, soil repellants, viscosity modifiers, and zirconium acid.

It is to be understood that any ingredient and/or ingredient amount may be combined with any other ingredient and/or ingredient amount herein.

The process described herein for making polyester nanocomposite compositions can also be integrated with additional forming processes, for example, by feeding the product, or co-feeding with an additional polymer stream, directly into an additional forming device, such as an extruder, extruder to form shaped articles, including but not limited to monofilament, multifilament yarn, film, sheet, pellets, and tubing. One example is an integrated continuous process for making monofilament in which the output of the extruder is fed directly into a filament extruder or co-fed into a filament extruder with an additional polymer stream.

### USES

Articles comprising the nanocomposite compositions produced by the present invention may be prepared by any means known in the art, such as, but not limited to, methods of injection molding, extrusion, blow molding, thermoforming, solution casting, or film blowing. They are particularly useful in appearance parts, packaging, monofilament, and other applications in which engineering plastics are typically used.

### Appearance parts

The compositions described herein (often when having additional optional ingredients present) are particularly useful as "appearance parts", that is parts in which the surface appearance is important. Such parts include automotive body panels such as fenders, fascia, hoods, tank flaps and other exterior parts; interior automotive panels; automotive lighting fixtures; parts for appliances (e.g., refrigerators, dishwashers, washing machines, clothes driers, food mixers, hair driers, coffee makers, toasters, and cameras), such as handles, control panels, chassises (cases), washing machine tubs and exterior parts, interior or exterior refrigerator panels, and dishwasher front or interior panels; power tool housings such as drills and saws; electronic cabinets and housings such as personal computer housings, printer housings, peripheral housings, server housings; exterior and interior panels for vehicles such as trains, tractors, lawn mower decks, trucks, snowmobiles, aircraft, and ships; decorative interior panels for buildings; furniture such as office and/or home chairs and tables; and telephones and other telephone equipment. As mentioned above these parts may be painted or they may be left unpainted in the color of the composition.

### Nonappearance parts

Nonappearance parts may also be made with these compositions. These are parts whose surface appearance is not critical. Such parts include those now made with so-called engineering thermoplastics, especially those which are filled with materials which are designed to enhance the composition's physical properties, such as stiffness, toughness, and tensile strength. Examples include but are not limited to electrical connectors, covers for switchboxes or fuses, radiator grille supports, headlamp mountings, printed circuit boards, plugs, switches, keyboard components, small electric motor components, distributor caps, bobbins, coil-formers, rotors, windshield wiper arms, headlight mountings, other fittings, and conveyor-belt links.

Where at least one polyester is a thermoplastic elastomer, the nanocomposites will find use in applications that involve some type of repeated mechanical movement, such as bending, flexing, pushing, rotating, pulsing, impacting, or recoiling, since they have a desirable combination of they have an excellent combination of strength, toughness, flexibility and recovery from deformation (see East, *op. cit.*). Examples of uses include but are not limited to hydraulic hosing, rail car couplers, release binders, auto vacuum control tubing, door lock bumpers, railroad car shock absorbers, headphones; specialty fibers, films, and sheets; jacketing, automotive shock absorbers, diaphragms for railroad cars, corrugated plastic tubing, railroad draft gear, auto electric window drive tapes, CVJ boots, recreational footware, conductive rubbers, wire coatings, energy management devices, telephone handset cords, compression spring pads, wire clamps, gun holsters, drive belts, run-flat tire inserts, and medical films.

### Packaging

Nanocomposite compositions made by the process described herein can be formed into shaped articles useful in packaging applications, such as film, sheet, container, membrane, laminate, pellet, coating, and foam. Articles may be prepared by any means known in the art, such as, but not limited to, methods of injection molding, (co)extrusion, blow molding, thermoforming, solution casting, lamination, and film blowing. The article may be an injection stretch blow molded bottle.

Examples of articles comprising nanocomposite compositions prepared by the process described herein include without limitation packaging for food, personal care (health and hygiene) items, and cosmetics. Packaging refers to either an entire package or a component of a package. Examples of packaging components include, but are not limited, to packaging film, liners, shrink bags, shrink wrap, trays (including but not limited to frozen food trays), tray/container assemblies, replaceable and nonreplaceable caps, lids, and drink bottle necks.

The package may be in any form appropriate for the particular application, such as a can, box, bottle, jar, bag, cosmetics package, or closed-ended tube. The packaging may be fashioned by any means known in the art, such as, but not limited to, extrusion, coextrusion, thermoforming, injection molding, lamination, or blow molding.

Some specific examples of packaging for personal care items and cosmetics include, but are not limited to, bottles, jars, and caps for food and for prescription and non-prescription capsules and pills; solutions, creams, lotions, powders, shampoos, conditioners, deodorants, antiperspirants, and suspensions for eye, ear, nose, throat, vaginal, urinary tract, rectal, skin, and hair contact; and lip product.

### Monofilament fiber and multifilament yarn

Polymeric monofilaments are used as reinforcements for rubber articles, fishing lines, toothbrush bristles, paintbrush bristles and the like. In addition, woven fabrics produced from monofilaments are used, for example, in industrial belts and paper machine clothing. Poly(ethylene terephthalate) ("PET") filaments are also employed in industrial applications such as tire cords, composites, belts, and textiles.

Multifilament yarns can be produced comprising the polyester nanocomposites described herein using any of the typical processes well known in the art for making multifilament polyester yarns (see, e.g., Reese, Glen, "Polyesters, Fibers" in Encyclopedia of Polymer Science and Technology, John Wiley & Sons, Inc. (2002), vol. 3, 652-678; U. S. Patents 3,409,496, 4,933,427, 4,929,698, 5,061,422, 5,277.858; British Patent 1,162,506). Textile filament yarns are continuous yarns produced at high speeds and are used for fabrics with silk-like esthetics. Industrial filament yarns are used for rubber reinforcement and high strength industrial fabrics.

### EXAMPLES

The present invention is further defined in the following Examples. It should be understood that these Examples, while indicating preferred embodiments of the invention, are given by way of illustration only. From the above discussion and these Examples, one skilled in the art can ascertain the essential characteristics of this invention, and without departing from the spirit and scope thereof, can make various changes and modifications of the invention to adapt it to various uses and conditions.

The meaning of abbreviations is as follows: "Bk" means break, "Flex" means flexural, "g" means gram(s), "h" means hour(s), "IV" means intrinsic viscosity, "ksi" means one thousand pounds per square inch, , "Ib" means pound(s), "min" means minute(s), "mm" means millimeter(s), "Mₙ" means number average molecular weight, "Mod" means modulus, "M_{w}" means weight average molecular weight, "oz" means ounce(s), "wt%" means weight percent(age), "RPM" means revolutions per minute, "SCFH" means standard cubic feet per hour, "SD" means standard deviation, "SEC" means size exclusion chromatography, "SSP" means solid state polymerization, and "TGA" means thermogravimetric analysis.

### Materials

Linear PET oligomer was obtained from E I. du Pont de Nemours & Co., Inc. (Wilmington, Delaware, USA) as a byproduct of a PET manufacturing process. The material contained 5.2% free glycol, as determined by extraction in acetone and gas chromatography. Characterization by matrix assisted laser desorption/ionization mass spectrometry ("MALDI") indicated the polyester was 4% monomer (i.e., bis(2-hydroxyethyl) terephthalate), 95% oligomer with a degree of polymerization from 2 through 14, and 1% oligomer with a degree of polymerization greater than 14.

Crystar ® 3905 PET homopolymer, IV=0.616, and Crystar ® 5005 PET homopolymer, IV=0.85, was obtained from E. I. du Pont de Nemours & Co., Inc., Wilmington, Delaware, USA.

Pangel® S-9 sepiolite and Pangel® S-15 sepiolite were purchased from EM Sullivan Associates, Inc. (Paoli, Pa, USA), a distributor for the manufacturer, Tolsa S.A. (Madrid 28001, Spain). Pangel® S-9 is a rheological grade of sepiolite that has an unmodified surface. Pangel® S-15 is a rheological grade of sepiolite which is a higher density, larger particle size version of Pangel® S-9 and is chemically identical to it.

### Nanocomposite Characterization.

A size exclusion chromatography system comprised of a Model Alliance 2690 from Waters Corporation (Milford, MA USA), with a Waters 410 refractive index detector (DRI) and Viscotek Corp. (Houston, TX, USA) Model T-60A^{™} dual detector module incorporating static right angle light scattering and differential capillary viscometer detectors was used for molecular weight characterization. The mobile phase was 1,1,1,3,3,3-hexafluoro-2-propanol (HFIP) with 0.01 M sodium trifluoroacetate. The dn/dc was measured for the polymers and it was assumed that all of the sample was completely eluted during the measurement.

Resin filler content was determined using thermogravimetric analysis ("TGA") as described in the Examples.

Tensile properties of molded parts were measured using ASTM Method D638 at an extension rate of 10%/min (0.2"/min with a 2" gage length).

Flexural properties (three point) of molded parts were measured using ASTM Method D790.

In the Examples, all parts are parts by weight.

### EXAMPLES 1-3

Examples 1-3 demonstrate the preparation of polyester nanocomposite masterbatches according to one embodiment.

As indicated in Table 1, a 30 mm Werner & Pfleiderer 9-barrel twin-screw extruder (Coperion Werner & Pfleiderer GmbH & Co. KG, Stuttgart, Germany) was used to compound various ratios of Pangel® S-9 sepiolite into a combination of both Crystar® 3905 PET pellets and linear PET oligomer in the form of solid flake. The ingredients were added simultaneously using three separate calibrated weight-loss feeders (K-Tron T-35 Twin-Screw for sepiolite and oligomer flake; K-Tron S-20 for PET pellets, K-Tron International, Pitman, New Jersey, USA) into a rear feed port of the extruder. Barrel temperatures ranged from 250 to 260°C. The resulting strands were quenched in a water bath and pelletized with a Conair 304 pelletizer (The Conair Group, Inc., Pittsburgh, Pennsylvania, USA).

**Table 1**

| | | Concentrations (wt. %) | | | Feeder Rate (Ib/h) | | | |
|---|---|---|---|---|---|---|---|---|
| Example Number | Total Feed Rate (lb/h) | Crystar® 3905 PET | Oligomer | Sepiolite | Crystar® 3905 PET | Oligomer | Sepiolite | Screw Speed (RPM) |
| 1 | 20 | 74 | 16 | 10 | 14.8 | 3.2 | 2 | 204 |
| 2 | 15 | 64 | 16 | 20 | 9.6 | 2.4 | 3 | 298 |
| 3 | 15 | 64 | 16 | 20 | 9.6 | 2.4 | 3 | 325 |

### EXAMPLES 4-6

Examples 4-6 demonstrate the preparation of polyester nanocomposite masterbatches, including solid phase polymerization.

As indicated in Table 2, a 30 mm Werner & Pfleiderer 9-barrel twin-screw extruder was used to compound various ratios of Pangel® S-9 sepiolite into a combination of both Crystar® 3905 PET pellets and linear PET oligomer in the form of solid flake. The ingredients were all added simultaneously using three separate calibrated weight-loss feeders (K-Tron T-35 Twin-Screw for sepiolite and oligomer; K-Tron S-20 for PET pellets) into a rear feed port of the extruder. Barrel temperatures ranged from 250 to 260°C. Compared to Examples 1-3, deeper flights were added in to the feed section of the screw to aid in conveying the powdery feed. The resulting strands were quenched in a water bath and pelletized with a Conair 304 pelletizer.

**Table 2**

| | | Concentrations (wt. %) | | | Feeder Rate (lb/h) | | | |
|---|---|---|---|---|---|---|---|---|
| Example Number | Total Feed Rate (Ib/h) | Crystar® 3905 PET | Oligomer | Sepiolite | Crystar® 3905 PET | Oligomer | Sepiolite | Screw Speed (RPM) |
| 4 | 20 | 64 | 20 | 16 | 12.8 | 4 | 3.2 | 253 |
| 5 | 30 | 64 | 20 | 16 | 19.2 | 6 | 4.8 | 376 |
| 6 | 20 | 64 | 16 | 20 | 12.8 | 3.2 | 4 | 377 |

The material from Example 5 was found by TGA (room temperature to 600°C in nitrogen and 600 to 900°C in air, 10°C/min) to have 11.9% filler. It was then solid-phase polymerized under vacuum with nitrogen purge in an oil-heated rotary tumbler (Patterson Conoform Rotary Cone Dryer, Taccoma, Georgia, 55 lbs capacity) for 15 hours with a maximum batch temperature of 211 °C. The weight average molecular weight of the polyester as measured by SEC increased from 17,890 to 22,980 over this time. The resin, designated MB-5-SSP, was then found by TGA to have 14.8% filler by weight.

### EXAMPLES 7-12, COMPARATIVE EXAMPLE A

Examples 7-12 demonstrate how a masterbatch can be let-down with added polymer to form compositions containing smaller amounts of sepiolite-type clay, by extrusion or pellet blending, followed by molding the compositions into parts.

The masterbatch resin prepared in Example 5, MB-5-SSP, was let-down with virgin Crystar® 3905 PET according to Table 3 in a second compounding using a Prism 18mm twin-screw extruder (Thermo PRISM, Staffordshire, England). A standard mixing screw design was used with temperatures of 260 to 270°C, a feed rate of 7.5 Ib/h, and a screw speed of 200 RPM.

**Table 3**

| Sample | Weight MB-5-SSP (g) | Weight Crystar® 3905 PET (g) | Crystar® 3905 PET:MB-5-SSP | Calculated Filler Content (wt.%) |
|---|---|---|---|---|
| 5A | 101 | 1715 | 17:1 | 0.82 |
| 5B | 302 | 1513 | 5:1 | 2.47 |
| 5C | 504 | 1311 | 2.6:1 | 4.11 |

These resins were then injection molded, according to Table 4, using an Arburg Allrounder 221 KS 350-100 1.5 oz injection molding machine (ARBURG GmbH + Co KG, Lossburg, Germany) with barrel temperatures of 265°C and a mold set temperature of 120°C (actual temperature=115°C maximum). Two pellet blends (i.e., pellets of the masterbatch physically mixed with pellets of neat Crystar® 3905 as dry blends, rather than being compounded in a second step), with ratios of Crystar® 3905 to MB-5-SSP of 5:1 ("5B(PB)") and 2.6:1 ("5C(PB)"), were made and molded,. In addition, in a Comparative Example, an *in situ* polymerized version of a nano-filled system, Crystar® 6920, was also injection molded. The Crystar® 6920 had been manufactured by polymerization of PET in the presence of Pangel® S-9 with a nominal sepiolite content of 3 wt%. ASTM tensile and flex bars were molded and subsequently tested according to standard procedures with results given in Table 5.

**Table 4**

| Sample | TGA-Measured Filler Content in Molding (wt%) |
|---|---|
| Crystar 6920 | |
| 5A | 0.91 |
| 5B | 2.43 |
| 5B(PB) | 2.46 |
| 5C | 3.97 |
| 5C(PB) | 5.57 |
| MB-5-SSP | 13.71 |

**Table 5**

| Example | Resin | Tensile Mod (SD)(ksi) | Break Stress(SD) (ksi) | Bk Strain (SD) (%) | Flex Mod (SD)(ksi) | Flex Strength (SD)(ksi) | Flex Strain (SD) (%) |
|---|---|---|---|---|---|---|---|
| Comp. Ex. A | Crystar® 6920 | 568.(10.8) | 7.45(0.45) | 1.43(0.08) | 567(14.7) | 13.6(0.21) | 2.54(0.09) |
| 7 | 5A | 444(24.0) | 6.21(0.50) | 1.50(0.18) | 486(10.7) | 14.2(1.17) | 3.27(0.41) |
| 8 | 5B | 507(39.8) | 6.58(0.32) | 1.39(0.10) | 523(10.8) | 12.5(0.5) | 2.53(0.13) |
| 9 | 5B(PB) | 525(40.6) | 6.00(0.45) | 1.26(0.13) | 511(8.43) | 12.4(1.86) | 2.61(0.52) |
| 10 | 5C | 526(30.9) | 5.71(0.11) | 1.12(0.07) | 589(15.9) | 10.4(0.69) | 1.82(0.13) |
| 11 | 5C(PB) | 604(13.4) | 5.70(0.25) | 0.97(0.04) | 634(10.1) | 9.88(0.44) | 1.60(0.08) |
| 12 | MB-5SSP | 895(12.2) | 4.01(0.19) | 0.52(0.11) | 904(14.2) | 8.72(0.84) | 0.97(0.09) |

### EXAMPLES 13-18

Examples 13-18 demonstrate preparation of various nanocomposite compositions and the effects of SSP conditions.

As indicated in Table 6, a 30 mm Werner & Pfleiderer 13-barrel twin-screw extruder was used to compound various ratios of Pangel® S-9 sepiolite into a combination of both Crystar® 3905 PET pellets and linear PET oligomer in the form of solid flake. The ingredients were all added simultaneously using three separate calibrated weight-loss feeders (K-Tron T-35 Twin-Screw for sepiolite and oligomer; K-Tron S-20 for PET pellets) into a rear port of the extruder. Barrel temperatures ranged from 250 to 320°C. A 45- degree-1/8 inch single hole die was used. The resulting strands were quenched in a water bath and pelletized with a Conair 304 pelletizer.

**Table 6**

| | | Concentrations (wt. %) | | | Feeder Rate (lb/h) | | | |
|---|---|---|---|---|---|---|---|---|
| Example Number | Total Feed Rate (lb/h) | Crystar® 3905 PET | Oligomer | Sepiolite | Crystar® 3905 PET | Oligomer | Sepiolite | Screw Speed (RPM) |
| 13 | 20 | 64 | 16 | 20 | 12.8 | 3.2 | 4 | 297 |
| 14 | 20 | 64 | 16 | 20 | 12.8 | 3.2 | 4 | 297 |
| 15 | 21.4 | 60 | 15 | 25 | 12.8 | 3.2 | 5.4 | 325 |
| 16 | 30 | 64 | 16 | 20 | 19.2 | 4.8 | 6 | 300 |
| 17 | 30 | 64 | 16 | 20 | 19.2 | 4.8 | 6 | 354 |
| 18 | 30 | 64 | 16 | 20 | 19.2 | 4.8 | 6 | 354 |

The material from Example 14 was solid-phase polymerized at the conditions indicated in Table 7 in a 2 inch diameter metal column surrounded by 1 inch thick thermal insulation. The indicated mass of pellets was placed inside a porous metal basket. This basket was placed inside the metal column. The samples were heated by nitrogen that had first been heated by a tubular heater. The nitrogen heater was controlled by a thermocouple placed between the metal column and thermal insulation and in intimate contact with the metal column. The molecular weights were measured by size exclusion chromatography.

**Table 7**

| Sample | Sample Mass (g) | Flow Rate (SCFH) | Temperature (°C) | SSP Time (h) | Mₙ | M_{w} | M_{w}/Mₙ |
|---|---|---|---|---|---|---|---|
| | | | | 0 | 5,770 | 12,000 | 2.08 |
| 14A | 40 | 80 | 180 | 2 | 6,080 | 11,100 | 1.83 |
| 14B | 100 | 150 | 180 | 2 | 6,690 | 10,700 | 1.6 |
| 14C | 40 | 150 | 180 | 24 | 8,120 | 13,300 | 1.64 |
| 14D | 80 | 100 | 220 | 4 | 1,120 | 16,900 | 1.51 |
| 14E | 80 | 100 | 220 | 18 | 18,500 | 31,200 | 1.69 |
| 14F | 100 | 80 | 230 | 2 | 11,500 | 20,100 | 1.75 |
| 14G | 80 | 80 | 230 | 22.5 | 21,060 | 42,550 | 2.02 |

### EXAMPLES 19-20

Examples 19 and 20 demonstrate the preparation of masterbatch resins using different mixing methods, followed by SSP and let-down into additional polyester polymer.

As indicated in Table 8, a 30 mm Werner & Pfleiderer 13-barrel twin-screw extruder was used to compound various ratios of Pangel® S-9 sepiolite into a combination of both Crystar® 3905 PET pellets and PET oligomer in the form of solid flake. The ingredients for Example 19 were all added simultaneously using three separate calibrated weight-loss feeders (K-Tron T-35 Twin-Screw for sepiolite and oligomer; K-Tron S-20 for PET pellets) into a rear feed port of the extruder. However, for Example 20, the appropriate quantities of sepiolite and oligomer, as indicated in Table 8, were first blended together in a polyethylene bag and then added to a single K-Tron T-35 feeder. Barrel temperatures ranged from 280 to 330°C. A 45-degree-1/8 inch single hole die was used. The resulting strands were quenched in a water bath and pelletized with a Conair 304 pelletizer.

**Table 8**

| | | Concentrations (wt. %) | | | Feeder Rate (lb/h) | | | | |
|---|---|---|---|---|---|---|---|---|---|
| Example Number | Total Feed Rate (lb/h) | Crystar® 3905 PET | Oligomer | Sepiolite | Crystar® 3905 PET | Oligomer | Sepiolite | Screw Speed (RPM) | TGA Sepiolite Content (wt %) |
| 19 | 30 | 64 | 16 | 20 | 19.2 | 4.8 | 6 | 307 | 17.3 |
| 20 | 30 | 64 | 16 | 20 | 19.2 | 10.8* | | 358 | 18.7 |

| | | | | | | | | | |
|---|---|---|---|---|---|---|---|---|---|
| *Feeder rate for oligomer/sepiolite blend | | | | | | | | | |

The resins made in Examples 15, 19, and 20 were solid-phase polymerized under vacuum with a nitrogen purge in a oil-heated rotary tumbler (Patterson Conoform Rotary Cone Dryer, Taccoma, Georgia, 55 lbs capacity) for 15-16 hours with a maximum batch temperature of 220°C. Over this time, the weight-average molecular weight of the resin (as measured by size exclusion chromatography) increased from 11,280 to 21,770; 16,270 to 25,140 and 15,000 to 24,100 for the pellets of Examples 15, 19, and 20 respectively. These solid-phased pellets, designated MB-15-SSP, MB-19-SSP, and MB-20-SSP, respectively, were then dry-blended in a polyethylene bag with neat Crystar® 3905 pellets according to the formulations of Table 9. These blends were then fed with a single K-Tron T-35 feeder into a rear feed port of a 30 mm Werner & Pfleiderer 13-barrel twin-screw extruder. Barrel temperatures ranged from 280 to 290°C. A 45-degree, 1/8 inch single hole die was used. The resulting strands were quenched in a water bath and pelletized with a Conair 304 pelletizer.

**Table 9**

| Masterbatch Resin | Estimated sepiolite content (wt%) | Weight Masterbatch Resin (g) | Weight Crystar® 3905 PET (g) | Estimated Sepiolite content of Let-Down (wt%) |
|---|---|---|---|---|
| MB-19-SSP | 18 | 832 | 4162 | 3 |
| MB-19-SSP | 18 | 1387 | 3607 | 5 |
| MB-20-SSP | 18 | 832 | 4162 | 3 |
| MB-20-SSP | 18 | 1387 | 3607 | 5 |
| MB-15-SSP | 22 | 681 | 4313 | 3 |
| MB-15-SSP | 22 | 1032 | 3508 | 5 |

### EXAMPLES 21-23

Examples 21-23 demonstrate the preparation of masterbatch resins using different relative amounts of linear polyester oligomer and polyester polymer, followed by SSP.

As indicated in Table 10, a 30 mm Werner & Pfleiderer 13-barrel twin-screw extruder was used to compound various ratios of Pangel® S-9 sepiolite into a combination of both Crystar® 3905 PET pellets and PET oligomer in the form of solid flake. The ingredients for Example 21 were all added simultaneously using three separate calibrated weight-loss feeders (K-Tron T-35 Twin-Screw for sepiolite and oligomer; K-Tron S-20 for PET pellets) into a rear feed port of the extruder. However, for Examples 22 and 23, the appropriate quantities of sepiolite and oligomer, as indicated in Table 10, were first blended together in a polyethylene bag and then added to a single K-Tron T-35 feeder. Barrel temperatures ranged from 280 to 320°C. A 45-degree-1/8 inch single hole die was used. The resulting strands were quenched in a water bath and pelletized with a Conair 304 pelletizer.

**Table 10**

| | | Concentrations (wt. %) | | | Feeder Rate (lb/h) | | | |
|---|---|---|---|---|---|---|---|---|
| Example Number | Total Feed Rate (lb/h) | Crystar® 3905 PET | Oligomer | Sepiolite wt% of Total | Crystar® 3905 PET | Oligomer | Sepiolite | Screw Speed (RPM) |
| 21 | 30 | 64 | 16 | 20 | 19.2 | 4.8 | 6 | 307 |
| 22 | 30 | 48 | 32 | 20 | 14.4 | 15.6 | | 300 |
| 23 | 30 | 32 | 48 | 20 | 9.6 | 20.4 | | 300 |

The pellets in Example 23 were solid-phase polymerized for the times and temperatures indicated in Table 11. These solid-phase polymerizations were performed in a 2 inch diameter metal column surrounded by 1 inch thick thermal insulation. Approximately 80 g of pellets was placed inside a porous metal basket. This basket was placed inside the metal column. The samples were heated by 80 SCFH nitrogen that had first been heated by a tubular heater. The nitrogen heater was controlled by a thermocouple placed between the metal column and thermal insulation and in intimate contact with the metal column. As indicated in Table 11, the molecular weights, as measured by size exclusion chromatography, significantly increased.

**Table 11**

| Temp [°C] | SSP time (h) | Mₙ | M_{w} | M_{w}/Mₙ |
|---|---|---|---|---|
| | 0 | 1,242 | 11,450 | 9.22 |
| 220 | 4 | 12,300 | 24,600 | 2.00 |
| 220 | 8 | 14,570 | 30,210 | 2.07 |
| 220 | 16 | 18,300 | 40,550 | 2.22 |
| 235 | 16 | 41,800 | 80,800 | 1.93 |

### EXAMPLES 24-28

Examples 24-28 demonstrate the preparation of masterbatch resins using different relative amounts of linear polyester oligomer and polyester polymer with two different grades of polyester polymer, followed by SSP.

As indicated in Table 12, a 30 mm Werner & Pfleiderer 13-barrel twin-screw extruder was used to compound various ratios of Pangel® S-9 sepiolite into a combination of both Crystar® PET pellets (grade 3905, IV=0.616, or 5005, IV=0.85, as noted) and linear PET oligomer in the form of solid flake. The ingredients were all added simultaneously using three separate calibrated weight-loss feeders (K-Tron T-35 Twin-Screw for sepiolite and oligomer; K-Tron S-20 for PET pellets) into a rear feed port of the extruder. Barrel temperatures ranged from 260 to 320°C. In each case, the total feed rate was 30 lb/h. The resulting strands were quenched in a water bath and pelletized with a Conair 304 pelletizer.

**Table 12**

| | | Concentrations (wt. %) | | | Feeder Rate (lb/h) | | | | |
|---|---|---|---|---|---|---|---|---|---|
| Example | Crystar® PET Grade | Crystar® PET | Oligomer | Sepiolite | Crystar ® PET | Oligomer | Sepiolite | Screw Speed (RPM) | TGA Sepiolite Content (%) |
| 24 | 3905 | 32 | 48 | 20 | 9.6 | 14.4 | 6 | 200-225 | 18.3 |
| 25 | 3905 | 48 | 32 | 20 | 14.4 | 9.6 | 6 | 225 | 17.3 |
| 26 | 3905 | 64 | 16 | 20 | 19.2 | 4.8 | 6 | 275 | 19.2 |
| 27 | 5005 | 64 | 16 | 20 | 19.2 | 4.8 | 6 | 300 | 18.6 |
| 28 | 5005 | 48 | 32 | 20 | 14.4 | 9.6 | 6 | 313-330 | 15.9 |

The resins from Examples 24, 25, and 26 were solid-phase polymerized using the equipment described above for Examples 21, 22, and 23. However, for the resin of Examples 24 and 25, the heating temperatures were ramped to prevent premature melting and subsequent pellet sticking. The molecular weights significantly increased.

**Table 13**

| | SSP Conditions | | | | |
|---|---|---|---|---|---|
| Resin | Temp [°C] | Time [h] | Mₙ | M_{w} | M_{w}/Mₙ |
| Ex. 24 | 180 | 2 | | | |
| | 210 | 4 | | | |
| | 230 | 18 | 16,380 | 38,890 | 2.37 |
| Ex. 25 | 180 | 2 | | | |
| | 200 | 3 | | | |
| | 210 | 3 | | | |
| | 230 | 14 | 19,120 | 43,480 | 2.27 |
| Ex. 26 | 230 | 22.5 | 23,540 | 50,470 | 2.14 |

### EXAMPLES 29-46

Examples 29-46 demonstrate preparation of nanocomposite masterbatch resins in which the oligomer was provided to the compounding extruder as a melt, rather than as a solid flake. To do this, a second 30 mm Werner & Pfleiderer twin-screw extruder (9 barrels) was used to melt and pump the oligomer. This extruder was fed with a K-Tron T-35 Twin-Screw calibrated weight-loss feeder, into a rear feed port. The rear several barrels were kept at 20-80°C to prevent premature melting of the oligomer. The front two barrels were set at 150°C and the die at 180°C. The screw design provided little work and mixing through essentially all conveying and pumping elements. The screw speeds were 150-200 RPM. The output of this extruder was then metered into a heated transfer line by a Zenith gear pump (Zenith® Pumps, a member of the Colfax Pump Group, Sanford, North Carolina, USA) and introduced into a rear feed port of the compounding extruder.

As indicated in Table 14, the same 30 mm Werner& Pfleiderer 13-barrel twin-screw extruder as was used in Examples 24-28 was used to compound various ratios of sepiolite (Pangel® S-9 or Pangel® S-15 as noted) into a combination of both Crystar® 3905 PET pellets and molten linear PET oligomer. The sepiolite and Crystar® 3905 PET were added simultaneously using two separate feeders (K-Tron T-35 Twin-Screw for sepiolite and K-Tron S-20 for PET pellets) into a rear feed port of the extruder. The oligomer melt was introduced two barrel sections downstream. Total feed rate in each case was 30 lb/h. Barrel temperatures ranged from 260 to 320°C. The resulting strands were quenched in a water bath and pelletized with a Conair 304 pelletizer.

**Table 14**

| | | Concentrations (wt %) | | | Feeder Rate (lb/h) | | | | |
|---|---|---|---|---|---|---|---|---|---|
| Example | Sepiolite Grade | Crystar® 3905 PET | Oligomer | Sepiolite | Crystar® PET | Oligomer | Sepiolite | Screw Speed (RPM) | TGA Sepiolite Content (%) |
| 29 | S-9 | 64 | 16 | 20 | 19.2 | 4.8 | 6 | 300 | 19.0 |
| 30 | S-9 | 48 | 32 | 20 | 14.4 | 9.6 | 6 | 300 | 17.2 |
| 31 | S-9 | 32 | 48 | 20 | 9.6 | 14.4 | 6 | 350 | 18.1 |
| 32 | S-9 | 16 | 64 | 20 | 4.8 | 19.2 | 6 | 400 | 17.9 |
| 33 | S-9 | 16 | 64 | 20 | 4.8 | 19.2 | 6 | 500 | 18.6 |
| 34 | S-9 | 64 | 60 | 25 | 4.5 | 18 | 7.5 | 400 | 22.9 |
| 35 | S-9 | 60 | 15 | 25 | 18.0 | 4.5 | 7.5 | 450 | 21.8 |
| 36 | S-9 | 56 | 14 | 30 | 16.8 | 4.2 | 9 | 500 | 27.0 |
| 37 | S-9 | 45 | 30 | 25 | 13.5 | 9 | 7.5 | 450 | 19.7 |
| 38 | S-9 | 30 | 45 | 25 | 9.0 | 13.5 | 7.5 | 450 | 23.1 |
| 39 | S-9 | 64 | 16 | 20 | 19.2 | 4.8 | 6 | 500 | 18.0 |
| 40 | S-9 | 48 | 32 | 20 | 14.4 | 9.6 | 6 | 500 | 18.1 |
| 41 | S-9 | 32 | 48 | 20 | 9.6 | 14.4 | 6 | 500 | 18.1 |
| 42 | S-15 | 64 | 16 | 20 | 19.2 | 4.8 | 6 | 300 | |
| 43 | S-15 | 48 | 32 | 20 | 14.4 | 9.6 | 6 | 300 | |
| 44 | S-15 | 48 | 32 | 20 | 14.4 | 9.6 | 6 | 500 | |
| 45 | S-15 | 32 | 48 | 20 | 9.6 | 14.4 | 6 | 300 | |
| 46 | S-15 | 32 | 48 | 20 | 9.6 | 14.4 | 6 | 500 | |

### EXAMPLES 47-50

Examples 47-50 demonstrate another means of preparing nanocomposite masterbatch resins in which the oligomer was provided to the compounding extruder as a melt, rather than as a solid flake. To do this, a second 30 mm Werner & Pfleiderer twin-screw extruder (9 barrels) was used to melt and pump the oligomer. This extruder was fed with a K-Tron T-35 Twin-Screw calibrated weight-loss feeder, into a rear feed port. The rear several barrels were kept at 20-80°C to prevent premature melting of the oligomer. The front two barrels were set at 150°C and the die at 180°C. The screw design provided little work and mixing through essentially all conveying and pumping elements. The screw speeds were 150-200 RPM. The output of this extruder was then metered into a heated transfer line by a Zenith gear pump and introduced into a rear feed port of the compounding extruder.

As indicated in Table 15, the same 30 mm Werner& Pfleiderer 13-barrel twin-screw extruder as was used in Examples 29-46 was used to compound various ratios of Pangel® S-9 sepiolite into a combination of both Crystar® 3905 PET pellets and PET oligomer, now in melt form. The PET was added using a K-Tron T-35 Twin-screw calibrated weight-loss feeder into a rear feed port of the extruder. The oligomer melt was introduced three barrel sections downstream. The sepiolite was then added in the next downstream barrel with a ZSB 25 side stuffer fed by a K-Tron T-35 calibrated weight-loss feeder. The total feed rate was 30 lb/h. Barrel temperatures ranged from 260 to 320°C. The resulting strands were quenched in a water bath and pelletized with a Conair 304 pelletizer.

**Table 15**

| | Concentrations (wt %) | | | Feeder Rate (lb/h) | | | |
|---|---|---|---|---|---|---|---|
| Example | Crystar® 3905 PET | Oligomer | Sepiolite | Crystar® 3905 PET | Oligomer | Sepiolite | Screw Speed (RPM) |
| 47 | 64 | 16 | 20 | 19.2 | 4.8 | 6 | 300 |
| 48 | 48 | 32 | 20 | 14.4 | 9.6 | 6 | 300 |
| 49 | 32 | 48 | 20 | 4.8 | 14.4 | 6 | 300 |
| 50 | 40 | 40 | 20 | 12 | 12 | 6 | 300 |

## Claims

1. A method for dispersing particles of sepiolite-type clay in a polyester matrix comprising melt-mixing a mixture of ingredients:
a. sepiolite-type clay,
b. at least one linear polyester oligomer, and
c. at least one polyester polymer
to produce a nanocomposite composition; and, optionally, subjecting said nanocomposite composition to solid state polymerization to increase polyester molecular weight.

2. The method of claim 1 wherein the ratio of the at least one linear polyester oligomer to the at least one polyester polymer is from about 1:99 to about 99:1 by weight.

3. The method of claim 1 wherein the amount of sepiolite-type clay is from about 0.1 to about 35 wt% based on the weight of the sepiolite-type clay plus the at least one linear polyester oligomer and at least one polyester polymer.

4. The method of claim 1 wherein the at least one linear polyester oligomer and/or the at least one polyester polymer is branched or unbranched, a homopolymer or copolymer, or a polymeric blend comprising at least one such homopolymer or copolymer.

5. The method of claim 1 wherein the at least one linear polyester oligomer and/or the at least one polyester polymer is selected from the group consisting of the following:
a. polyesters produced from reaction mixtures containing one or more diols and one or more hydrocarbyl diacids or esters of such diacids, wherein the diols are selected from the group consisting of ethylene glycol, 1,3-propylene glycol, 1,2-propylene glycol, 2,2-diethyl-1,3-propane diol, 2,2-dimethyl-1,3-propane diol, 2-ethyl-2-butyl-1,3-propane diol, 2-ethyl-2-isobutyl-1,3-propane diol, 1,3-butane diol, 1,4-butane diol, 1,5-pentane diol, 1,6-hexane diol, 2,2,4-trimethyl-1,6-hexane diol, 1,2-cyclohexane dimethanol, 1,3-cyclohexane dimethanol, 1,4-cyclohexane dimethanol, 2,2,4,4-tetramethyl-1,3-cyclobutane diol, isosorbide, naphthalene glycols, biphenols, diethylene glycol, triethylene glycol, resorcinol, hydroquinone, t-butyl-hydroquinone, polytetramethylene ether glycol and other longer chain diols and polyols which are the reaction products of diols or polyols with alkylene oxides, and alkyl-substituted and chloro-substituted versions of said diols; and the diacids are selected form the group consisting of terephthalic acid, isophthalic acid, naphthalene dicarboxylic acids, cyclohexane dicarboxylic acids, succinic acid, glutaric acid, adipic acid, sebacic acid, 1,12-dodecane dioic acid, fumaric acid, maleic acid, and alkyl-substituted and chloro-substituted versions of said diacids;
b. polyesters produced from reaction mixtures containing one or more polymerizable polyester monomers selected from the group consisting of hydroxybenzoic acids, hydroxynaphthoic acids, lactic acid, bis(2-hydroxyethyl) terephthalate, bis(4-hydroxybutyl) terephthalate, bis(2-hydroxyethyl)naphthalenedioate, bis(2-hydroxyethyl)isophthalate, bis[2-(2-hydroxyethoxy)ethyl]terephthalate, bis[2-(2-hydroxyethoxy)ethyl]isophthalate, bis[(4-hydroxymethylcyclohexyl)methyl]terephthalate, and bis[(4-hydroxymethylcyc)ohexylmethyl]isophthalate, mono(2-hydroxyethyl)terephthalate, bis(2-hydroxyethyl)sulfoisophthalate, lactide, and alkyl-substituted and chloro-substituted versions of said polymerizable polyester monomers; and
c. polyesters produced directly from reaction mixtures containing macrocyclic polyester oligomers selected from the group consisting of macrocyclic polyester oligomers of: 1,4-butylene terephthalate,1,3-propylene terephthalate, 1,4-cyclohexylenedimethylene terephthalate, ethylene terephthalate, 1,2-ethylene 2,6-naphthalenedicarboxylate, the cyclic ester dimer of terephthalic acid and diethylene glycol, macrocyclic co-oligoesters comprising two or more of the above structural repeat units, and alkyl-substituted and chloro-substituted versions of said macrocyclic polyester oligomers.

6. The method of claim 5 wherein the at least one linear polyester oligomer and/or the at least one polyester polymer is selected from the group consisting of the following: poly(ethylene terephthalate), poly(1,3-propylene terephthalate), poly(1,4-butylene terephthalate, a thermoplastic elastomeric polyester having poly(1,4-butylene terephthalate) and poly(tetramethylene ether)glycol blocks, poly(1,4-cylohexyldimethylene terephthalate), and polylactic acid.

7. The method of claim 1 wherein the sepiolite-type clay is unmodified.

8. The method of claim 1 wherein the sepiolite-type clay is rheological grade.

9. The method of claim 1 wherein the melt-mixing is carried out using at least one twin-screw extruder.

10. The The method of claim 9 wherein some or all of the output of one twin-screw extruder is re-fed one or more times through the same extruder.

11. The method of claim 9 wherein the at least one linear polyester oligomer and/or the at least one polyester polymer is fed as a melt.

12. The method of claim 9 wherein the sepiolite-type clay is fed as a slurry in an additional ingredient.

13. The method of claim 9 further comprising staged feeding.

14. The method of claim 13 wherein the sepiolite-type clay and the at least one linear polyester oligomer are fed as a dry blend and the at least one polyester polymer is fed as a separate component.

15. The method of claim 13 wherein at least one polyester polymer is fed into a first feed port and the sepiolite-type clay and the at least one linear polyester oligomer are fed either as a blend into a second feed port or separately into second and third feed ports downstream.

16. The method of claim 13 wherein the at least one linear polyester oligomer and the at least one polyester polymer are fed into a first feed port of the extruder, and the sepiolite-type clay is fed into a second port downstream.

17. The method of claim 9 further comprising split feeding at least one ingredient.

18. The method of claim 17 comprising split feeding the sepiolite-type clay.

19. The method of claim 9 further comprising the step of feeding the output of the extruder, or co-feeding said output with an additional polymer stream, into an additional forming device to form a shaped article.

20. The method of claim 19 wherein the additional forming device is an extruder.

21. The method of claim 19 wherein the shaped article is selected from the group consisting of monofilament, multifilament yam, film, sheet, tubing, and pellets.

22. The method of claim 1 further comprising addition of at least one ingredient selected from the group consisting of antioxidants, toughening agents, pigments, solid particulate filler exclusive of the sepiolite-type clay, plasticizers, epoxy compounds and resins, hydrolysis stabilizers, lubricants, mold release, flame retardants, other polymers, adhesion promoters, thermal stabilizers, UV absorbers, UV stabilizers, processing aids, waxes, color stabilizers, pigments, nucleants, dyes, delusterants, antiblocks, antistats, brighteners, silicon nitride, metal ion sequestrants, anti-staining agents, silicone oil, surfactants, soil repellants, viscosity modifiers, and zirconium acid.

23. A method for preparing a polyester nanocomposite composition from a masterbatch, comprising melt-compounding a mixture of: sepiolite-type clay, at least one polyester oligomer, and at least one polyester polymer to produce a nanocomposite composition containing a greater concentration of sepiolite-type clay than is desired in the final resin composition; optionally, subjecting said nanocomposite composition to solid state polymerization to increase the polyester molecular weight; and further melt compounding said nanocomposite composition with polyester polymer and, optionally, additional ingredients.

24. A shaped article comprising the polyester nanocomposite composition produced by the method of claim 1 or claim 23, wherein the article is formed using at least one method selected from the group consisting of injection molding, (co)extrusion, blow molding, thermoforming, solution casting, lamination, and film blowing.

25. The shaped article of claim 23 wherein said shaped article is selected from the group consisting of:
a. appearance parts selected from the group consisting of automotive body panels, fenders, fascia, hoods, tank flaps and other exterior parts; interior automotive panels; automotive lighting fixtures; appliance handles, control panels, chassises (cases), washing machine tubs and exterior parts, interior or exterior refrigerator panels, and dishwasher front or interior panels; power tool housings; electronic cabinets and housings; exterior and interior panels for vehicles; decorative interior panels for buildings; office and home furniture: telephones and other telephone equipment;
b. non-appearance parts selected from the group consisting of electrical connectors, covers for switchboxes or fuses, radiator grille supports, headlamp mountings, printed circuit boards, plugs, switches, keyboard components, small electric motor components, distributor caps, bobbins, coil-formers, rotors, windshield wiper arms, headlight mountings, other fittings, conveyor-belt links, hydraulic hosing, rail car couplers, release binders, auto vacuum control tubing, door lock bumpers, railroad car shock absorbers, headphones; specialty fibers, films, and sheets; jacketing, automotive shock absorbers, diaphragms for railroad cars, corrugated plastic tubing, railroad draft gear, auto electric window drive tapes, CVJ boots, recreational footware, conductive rubbers, wire coatings, energy management devices, telephone handset cords, compression spring pads, wire clamps, gun holsters, drive belts, run-flat tire inserts, and medical films;
c. packaging selected from the group consisting of packaging film, liners, shrink bags, shrink wrap, frozen food trays, other trays, tray/container assemblies, replaceable and nonreplaceable caps, lids, drink bottle necks, cans, boxes, bottles, jars, bags, cosmetics packages, and closed-ended tubes; and
d. monofilaments, multifilament yarn, fishing lines, toothbrush bristles, paintbrush bristles, industrial belts and paper machine clothing comprising woven fabrics produced from monofilaments, tire cords, composites, belts, textiles, reinforced rubber, and high strength industrial fabrics.

## Patentansprüche

1. Verfahren zum Dispergieren von Teilchen von Ton vom Sepiolit-Typ in einer Polyestermatrix, umfassend das Schmelzmischen einer Mischung von Bestandteilen:
a) Ton vom Sepiolit-Typ,
b) mindestens einem linearen Polyesteroligomer und
c) mindestens einem Polyesterpolymer
unter Bildung einer Nanokompositzusammensetzung; und wahlweise das Unterwerfen der Nanokompositzusammensetzung einer Festphasenpolymerisation, um das Molekulargewicht des Polyesters zu erhöhen.

2. Verfahren nach Anspruch 1, wobei das Verhältnis des mindestens einen linearen Polyesteroligomers zu dem mindestens einen Polyesterpolymer etwa 1:99 bis etwa 99:1, auf das Gewicht bezogen, beträgt.

3. Verfahren nach Anspruch 1, wobei die Menge an Ton vom Sepiolit-Typ etwa 0,1 bis etwa 35 Gew.-%, auf das Gewicht des Tons vom Sepiolit-Typ bezogen, plus dem mindestens einen linearen Polyesteroligomer und mindestens einen Polyesterpolymer beträgt.

4. Verfahren nach Anspruch 1, wobei das mindestens eine lineare Polyesteroligomer und/oder das mindestens eine Polyesterpolymer verzweigt oder unverzweigt, ein Homopolymer oder Copolymer oder eine Polymermischung ist, die mindestens ein derartiges Homopolymer oder Copolymer umfasst.

5. Verfahren nach Anspruch 1, wobei das mindestens eine lineare Polyesteroligomer und/oder das mindestens eine Polyesterpolymer aus der Gruppe ausgewählt ist bestehend aus folgenden:
a. Polyestern, die aus Reaktionsmischungen hergestellt werden, die ein oder mehrere Diole und eine oder mehrere Hydrocarbyldisäuren oder Ester solcher Disäuren enthalten, wobei die Diole aus der Gruppe ausgewählt sind bestehend aus Ethylenglykol, 1,3-Propylenglykol, 1,2-Propylenglykol, 2,2-Diethyl-1,3-propandiol, 2,2-Dimethyl-1,3-Propandiol, 2-Ethyl-2-butyl-1,3-propandiol, 2-Ethyl-2-isobutyl-1,3-propandiol, 1,3-Butandiol, 1,4-Butandiol, 1,5-Pentandiol, 1,6-Hexandiol, 2,2,4-Trimethyl-1,6-hexandiol, 1,2-Cyclohexandimethanol, 1,3-Cyclohexandimethanol, 1,4-Cyclohexandimethanol, 2,2,4,4-Tetramethyl-1,3-cyclobutandiol, Isosorbid, Naphthalinglykolen, Biphenolen, Diethylenglykol, Triethylenglykol, Resorcinol, Hydrochinon, tert-Butylhydrochinon, Polytetramethylenetherglykol und anderen längerkettigen Diolen und Polyolen, die die Reaktionsprodukte von Diolen oder Polyolen mit Alkylenoxiden sind und alkylsubstituierten und chlorsubstituierten Versionen der Diole; und die Disäuren aus der Gruppe ausgewählt sind bestehend aus Terephthalsäure, Isophthalsäure, Naphthalindicarbonsäuren, Cyclohexandicarbonsäuren, Bernsteinsäure, Glutarsäure, Adipinsäure, Sebacinsäure, 1,12-Dodecandionsäure, Fumarsäure, Maleinsäure und alkylsubstituierten und chlorsubstituierten Versionen der Disäuren;
b. Polyestern hergestellt aus Reaktionsmischungen, die einen oder mehrere polymerisierbare Polyestermonomer(e) enthalten, die aus der Gruppe ausgewählt ist/sind bestehend aus Hydroxybenzoesäuren, Hydroxynaphthoesäuren, Milchsäure, Bis(2-hydroxyethyl)terephthalat, Bis(4-hydroxybutyl)terephthalat, Bis(2-hydroxyethyl)naphthalindioat, Bis(2-Hydroxyethyl)isophthalat, Bis[2-(2-hydroxyethoxy)ethyl]terephthalat, Bis[2-(2-hydroxyethoxy)ethyl]isophthalat, Bis[(4-hydroxymethylcyclohexyl)methyl]terephthalat und Bis[(4-hydroxymethylcyclohexyl)methyl]isophthalat, Mono(2-hydroxyethyl)terephthalat, Bis(2-hydroxyethyl)sulfoisophthalat, Lactid und alkylsubstituierten und chlorsubstituierten Versionen der polymerisierbaren Polyestermonomere und
c. Polyestern hergestellt direkt aus Reaktionsmischungen, die makrocyclische Polyesteroligomere enthalten ausgewählt aus der Gruppe bestehend aus makrocyclischen Polyesteroligomeren von: 1,4-Butylenterephthalat, 1,3-Propylenterephthalat, 1,4-Cyclohexylendimethylenterephthalat, Ethylenterephthalat, 1,2-Ethylen-2,6-naphthalindicarboxylat, dem cyclischen Esterdimer von Terephthalsäure und Diethylenglykol, makrocyclischen Cooligoestem umfassend zwei oder mehrere der obigen strukturellen Wiederholungseinheiten und alkylsubstituierte und chlorsubstituierte Versionen der makrocyclischen Polyesteroligomere.

6. Verfahren nach Anspruch 5, wobei das mindestens eine lineare Polyesteroligomer und/oder das mindestens eine Polyesterpolymer aus der Gruppe ausgewählt ist/sind bestehend aus Folgenden: Poly(ethylenterephthalat), Poly(1,3-propylenterephthalat), Poly(1,4-Butylenterephthalat), einem thermoplastischen elastomeren Polyester, der Poly(1,4-butylenterephthalat)- und Poly(tetramethylenether)glykolblöcke aufweist, Poly(1,4-cyclohexyldimethylenterephthalat) und Polymilchsäure.

7. Verfahren nach Anspruch 1, wobei der Ton vom Sepiolit-Typ unmodifiziert ist.

8. Verfahren nach Anspruch 1, wobei der Ton vom Sepiolit-Typ von rheologischer Qualität ist.

9. Verfahren nach Anspruch 1, wobei das Schmelzmischen mit Hilfe mindestens eines Doppelschneckenextruders durchgeführt wird.

10. Verfahren nach Anspruch 9, wobei ein Teil oder der gesamte Ausstoß aus dem Doppelschneckenextruder erneut ein- oder zweimal durch denselben Extruder hindurchgeführt wird.

11. Verfahren nach Anspruch 9, wobei das mindestens eine lineare Polyesteroligomer und/oder das mindestens eine Polyesterpolymer als Schmelze eingespeist wird.

12. Verfahren nach Anspruch 9, wobei der Ton vom Sepiolit-Typ als Aufschlämmung einem zusätzlichen Bestandteil eingegeben wird.

13. Verfahren nach Anspruch 9, des Weiteren stufenweises Einspeisen umfassend.

14. Verfahren nach Anspruch 13, wobei der Ton vom Sepiolit-Typ und das mindestens eine lineare Polyesteroligomer als trockene Mischung eingespeist werden und das mindestens eine Polyesterpolymer als getrennte Komponente eingespeist wird.

15. Verfahren nach Anspruch 13, wobei mindestens ein Polyesterpolymer in eine erste Einspeiseöffnung eingespeist wird und der Ton vom Sepiolit-Typ und das mindestens eine lineare Polyesteroligomer entweder als Mischung in eine zweite Einspeiseöffnung oder getrennt in eine zweite und dritte Einspeiseöffnung stromabwärts eingespeist werden.

16. Verfahren nach Anspruch 13, wobei das mindestens eine lineare Polyesteroligomer und das mindestens eine Polyesterpolymer in eine erste Einspeiseöffnung des Extruders eingespeist werden und der Ton vom Sepiolit-Typ in eine zweite Öffnung stromabwärts eingespeist wird.

17. Verfahren nach Anspruch 9, des Weiteren das getrennte Einspeisen mindestens eines Bestandteils umfassend.

18. Verfahren nach Anspruch 17 umfassend das getrennte Einspeisen des Tons vom Sepiolit-Typ.

19. Verfahren nach Anspruch 9, des Weiteren umfassend den Schritt des Einspeisens des Ausstoßes des Extruders und gleichzeitigen Einspeisens des Ausstoßes mit einem zusätzlichen Polymerstrom in ein zusätzliches Formungsgerät zur Bildung eines geformten Gegenstands.

20. Verfahren nach Anspruch 19, wobei das zusätzliche Formungsgerät ein Extruder ist.

21. Verfahren nach Anspruch 19, wobei der geformte Gegenstand aus der Gruppe ausgewählt ist bestehend aus Monofilament-, Multifilamentgarn, Folie, Platte, Rohr und Granulat.

22. Verfahren nach Anspruch 1 des Weiteren umfassend das Hinzusetzen mindestens eines Bestandteils ausgewählt aus der Gruppe bestehend aus Antioxidantien, Schlagzähigkeitsverbesserern, Pigmenten, festem teilchenförmigem Füllstoff ausschließlich des Tons vom Sepiolit-Typ, Weichmachern, Epoxidverbindungen und -harzen, Hydrolysestabilisatoren, Gleitmitteln, Entformungshilfsmitteln, Brandschutzmitteln, anderen Polymeren, Haftmitteln, Wärmestabilisatoren, UV-Absorptionsmitteln, UV-Stabilisatoren, Verarbeitungshilfsmitteln, Wachsen, Farbstabilisatoren, Pigmenten, Keimmitteln, Farbstoffen, Mattiermitteln, Antiblöcken, Antistatikmitteln, Aufhellern, Siliciumnitrid, Metallionensequestriennitteln, Fleckenverhütungsmitteln, Siliconöl, Tensiden, Schmutzabweisungsmitteln, Viskositätsmodifizierrnitteln und Zirconiumsäure.

23. Verfahren für die Herstellung einer Polyesternanokompositzusammensetzung aus einem Masterbatch umfassend das Schmelzkompoundieren einer Mischung von: Ton vom Sepiolit-Typ, mindestens einem Polyesteroligomer und mindestens einem Polyesterpolymer zur Bildung einer Nanokompositzusammensetzung, die eine höhere Konzentration von Ton vom Sepiolit-Typ enthält als in der endgültigen Harzzusammensetzung erwünscht ist; wahlweise das Unterwerfen der Nanokompositzusammensetzung einer Festphasenpolymerisation, um das Molekulargewicht des Polyesters zu erhöhen; und des Weiteren das Schmelzkompoundieren der Nanokompositzusammensetzung mit Polyesterpolymer und wahlweise zusätzlichen Bestandteilen.

24. Geformter Gegenstand umfassend die Polyesternanokompositzusammensetzung, die durch das Verfahren nach Anspruch 1 oder Anspruch 23 hergestellt worden ist, wobei der Gegenstand unter Anwendung mindestens eines Verfahrens geformt wird, das aus der Gruppe ausgewählt ist bestehend aus Spritzgießen, (Co)extrudieren, Blasformen, Thermoformen, Lösungsgießen, Laminieren und Folienblasen.

25. Geformter Gegenstand nach Anspruch 23, wobei der geformte Gegenstand aus der Gruppe ausgewählt ist bestehend aus:
a. Teilen für das Äußere ausgewählt aus der Gruppe bestehend aus Motorkarosserieverkleidungen, Kotflügeln, Armaturentafeln, Motorhauben, Tankklappen und anderen Außenteilen; Fahrzeuginnenverkleidungen; Fahrzeugbeleuchtungsvorrichtungen; Gerätegriffe, Bedientafeln, Montagerahmen (Gehäusen), Waschmaschinentrommeln und Außenteilen, Innen- oder Außenkühlschrankverkleidungen und Vorder- oder Innenverkleidungen für Geschirrspülmaschinen; Elektrowerkzeuggehäusen; Elektronikkästen und -gehäusen; Außen- und Innenverkleidungen für Fahrzeuge; dekorativen Innenverkleidungen für Gebäude; Möbeln für Büro und Heim; Telefonen und anderen Telefonausrüstungen;
b. Teilen nicht für das Äußere ausgewählt aus der Gruppe bestehend aus elektrischen Verbindungen, Abdeckungen für Schaltkästen oder Kühlergrillabstützungen, Scheinwerferfassungen, gedruckten Schaltungen, Anschlusssteckern, Schaltern, Tastaturteilen, kleinen elektrischen Motorenkomponenten, Verteilerkappen, Spulen, Wickelkörperformern, Rotoren, Scheibenwischerarmen, Vorderlichtfassungen, anderen Armaturen, Förderbandgliedern, hydraulischen Schläuchen, Eisenbahnwagenkupplungen, Freiauslöseverbindungen, Fahrzeugvakuumregulierrohren, Türschlossstoßfängem, Eisenbahnstoßdämpfern, Kopfhörern; Spezialfasern, Folien und Platten; Verkleidungen, Fahrzeugstoßfängern, Membranen für Eisenwahnwagen, Wellkunststoffröhren, Eisenbahnzugausrüstung, Antriebsbändern für elektrische Fahrzeugfenster, Gleichlaufgelenkmuffen, Schuhwerk für Freizeitaktivitäten, leitfähigen Kautschukarten, Drahtbeschichtungen, Energielenkungsgeräten, Telefonhandapparatkabeln, Druckfederkissen, Drahtklemmen, Pistolenhaltern, Antriebsriemen, Reifen mit Einsätzen für Notlaufeigenschaften und medizinischen Folien;
c. Verpackungen ausgewählt aus der Gruppe bestehend aus Verpackungsfolien, Auskleidungen, Schrumpfbeuteln, Schrumpffolienmaterialien, Gefrierkostschalen, anderen Schalen, Schalen/Behältersätzen, ersetzbaren und nichtersetzbaren Kappen, Deckeln, Getränkeflaschenhälsen, Dosen, Kästen, Flaschen, Gläsern, Beuteln, Verpackungen für Kosmetika und Röhren mit geschlossenen Enden;
d. Monofilamenten, Multifilamentgarn, Angelschnüren, Zahnbürstenborsten, Malerpinselborsten, Industriebändern und Papiermaschinenbekleidung umfassend Webwaren, die aus Monofilamenten hergestellt sind, Reifencorden, Verbundstoffen, Gürteln, Textilien, verstärktem Kautschuk und hochfestem Industriegewebe.

## Revendications

1. Procédé de dispersion de particules d'argile de type sépiolite dans une matrice de polyester comprenant le mélange à l'état fondu d'un mélange d'ingrédients:
a. argile de type sépiolite,
b. au moins un oligomère de type polyester linéaire, et
c. au moins un polymère de type polyester
pour produire une composition pour nanocomposites; et, éventuellement, la soumission de ladite composition pour nanocomposites à la polymérisation à l'état solide afin d'augmenter le poids moléculaire du polyester.

2. Procédé selon la revendication 1, dans lequel le rapport du au moins un oligomère de type polyester linéaire sur le au moins un polymère de type polyester est d'environ 1:99 jusqu'à environ 99:1 en poids.

3. Procédé selon la revendication 1, dans lequel la quantité d'argile de type sépiolite est d'environ 0,1 jusqu'à environ 35 % en poids basée sur le poids de l'argile de type sépiolite plus du au moins un oligomère de type polyester linéaire et du au moins un polymère de type polyester.

4. Procédé selon la revendication 1, dans lequel le au moins un oligomère de type polyester linéaire et/ou le au moins un polymère de type polyester est ramifié ou non ramifié, un homopolymère où copolymère, ou un mélange polymère comprenant au moins l'un parmi un tel homopolymère ou copolymère.

5. Procédé selon la revendication 1, dans lequel le au moins un oligomère de type polyester linéaire et/ou le au moins un polymère de type polyester est choisi parmi le groupe constitué de ce qui suit:
a. les polyesters produits à partir des mélanges réactionnels contenant un ou plusieurs diol(s) et un ou plusieurs diacide(s) d'hydrocarbyle ou esters de tels diacides, dans lesquels les diols sont choisis parmi le groupe constitué de l'éthylène glycol, du 1,3-propylène glycol, 1,2-propylène glycol, 2,2-diéthyl-1,3-propane diol, 2,2-diméthyl-1,3-propane diol, 2-éthyl-2-butyl-1,3-propane diol, 2-éthyl-2-isobutyl-1,3-propanediol, 1,3-butanediol, 1,4-butane diol, 1,5-pentane diol, 1,6-hexane diol, 2,2,4-triméthyl-1,6-hexane diol, 1,2-cyclohexane diméthanol, 1,3-cyclohexane diméthanol, 1,4-cyclohexane diméthanol, 2,2,4,4-tétraméthyl-1,3-cyclobutane diol, de l'isosorbide, des naphtalène glycols, biphénols, du diéthylène glycol, triéthylène glycol, résorcinol, de l'hydroquinone, de la t-butyl-hydroquinone, du polytétraméthylène éther glycol et d'autres diols à chaîne plus longue et polyols qui sont les produits réactionnels de diols ou de polyols avec des oxydes d'alkylène, et les versions substituées par un groupe alkyle et substituées par un groupe chloro desdits diols; et les diacides sont choisis parmi le groupe constitué de l'acide téréphtalique, acide isophtalique, des acides naphtalène dicarboxyliques, acides cyclohexane dicarboxyliques, de l'acide succinique, acide glutarique, acide adipique, acide sébacique, acide 1,12-dodécane dioïque, acide fumarique, acide maléique, et des versions substituées par un groupe alkyle et substituées par un groupe chloro desdits diacides;
b. les polyesters produits à partir des mélanges réactionnels contenant un ou plusieurs monomère(s) de type polyester polymérisable(s) choisi(s) parmi le groupe constitué des acides hydroxybenzoïques, acides hydroxynaphtoïques, de l'acide lactique, du téréphtalate de bis(2-hydroxyéthyle), téréphtalate de bis(4-hydroxybutyl), bis(2-hydroxyéthyl)naphtalènedioate, bis(2-hydroxyéthyl)isophtalate, bis[2-(2-hydroxyéthoxy)éthyl]téréphtalate, bis[2-(2-hydroxyéthoxy)éthyl]isophtalate, bis[(4-hydroxyméthylcyclohexyl)méthyl]téréphtalate, et bis[(4-hydroxyméthylcyclohexyl)méthyl]isophtalate, mono(2-hydroxyéthyl)téréphtalate, bis(2-hydroxyéthyl)sulfoisophtalate, lactide, et des versions substituées par un groupe alkyle et substituées par un groupe chloro desdits monomères de type polyester polymérisables; et
c. les polyesters produits directement à partir de mélanges réactionnels contenant les oligomères de polyester macrocycliques choisis parmi le groupe constitué des oligomères de polyester macrocycliques de: téréphtalate de 1,4-butylène, téréphtalate de 1,3-propylène, téréphtalate de 1,4-cyclohexylènediméthylène, téréphtalate d'éthylène, 2,6-naphtalènedicarboxylate de 1,2-éthylène, le dimère de l'ester cyclique de l'acide téréphtalique et du diéthylène glycol, les co-oligoesters macrocycliques comprenant deux ou plusieurs des motifs de répétition structurels ci-dessus, et les versions substituées par un groupe alkyle et substituées par un groupe chloro desdits oligomères de type polyester macrocycliques.

6. Procédé selon la revendication 5, dans lequel le au moins un oligomère de type polyester linéaire et/ou le au moins un polymère de type polyester est(sont) choisi(s) parmi le groupe constitué de ce qui suit: le poly(téréphtalate d'éthylène), poly(téréphtalate de 1,3-propylène), poly(téréphtalate de 1,4-butylène), un polyester élastomère thermoplastique ayant du poly(téréphtalate de 1,4-butylène) et des séquences de poly(éther de tétraméthylène)glycol, le poly(téréphtalate de 1,4-cylohexyldiméthylène), et le poly(acide lactique).

7. Procédé selon la revendication 1, dans lequel l'argile de type sépiolite est non modifiée.

8. Procédé selon la revendication 1, dans lequel l'argile de type sépiolite est de qualité rhéologique.

9. Procédé selon la revendication 1; dans lequel le mélange à l'état fondu est conduit en utilisant au moins une extrudeuse double vis.

10. Procédé selon la revendication 9, dans lequel une partie ou tout le produit d'une extrudeuse double vis est rechargé(e) une ou plusieurs fois à travers la même extrudeuse.

11. Procédé selon la revendication 9, dans lequel le au moins un oligomère de type polyester linéaire et/ou le au moins un polymère de type polyester est chargé sous la forme d'une masse fondue.

12. Procédé selon la revendication 9, dans lequel l'argile de type sépiolite est chargée sous la forme d'une bouillie dans un ingrédient supplémentaire.

13. Procédé selon la revendication 9, comprenant en outre l'alimentation étagée.

14. Procédé selon la revendication 13, dans lequel l'argile de type sépiolite et le au moins un oligomère de type polyester linéaire sont chargés sous la forme d'un mélange sec et le au moins un polymère de type polyester est chargé sous la forme d'un composant séparé.

15. Procédé selon la revendication 13, dans lequel au moins un polymère de type polyester est chargé dans un premier orifice d'alimentation et l'argile de type sépiolite et le au moins un oligomère de type polyester linéaire sont chargés soit sous la forme d'un mélange dans un second orifice d'alimentation soit séparément dans un second et un troisième orifice d'alimentation en aval.

16. Procédé selon la revendication 13, dans lequel le au moins un oligomère de type polyester linéaire et le au moins un polymère de type polyester sont chargés dans un premier orifice d'alimentation de l'extrudeuse, et l'argile de type sépiolite est chargée dans un second orifice en aval.

17. Procédé selon la revendication 9, comprenant en outre l'alimentation fractionnée d'au moins un ingrédient.

18. Procédé selon la revendication 17, comprenant l'alimentation fractionnée de l'argile de type sépiolite.

19. Procédé selon la revendication 9, comprenant en outre l'étape d'alimentation du produit de l'extrudeuse, ou la co-alimentation dudit produit avec un écoulement supplémentaire de polymère, dans un dispositif de mise en forme supplémentaire afin de former un article mis en forme.

20. Procédé selon la revendication 19, dans lequel le dispositif de mise en forme supplémentaire est une extrudeuse.

21. Procédé selon la revendication 19, dans lequel l'article mis en forme est choisi parmi le groupe constitué d'un monofilament, d'un fil à filaments multiples, d'un film, d'une feuille, d'un tube, et de pastilles.

22. Procédé selon la revendication 1, comprenant en outre l'addition d'au moins un ingrédient choisi parmi le groupe constitué des antioxydants, des agents durcissants, des pigments, d'une charge solide sous forme de particule hors argile de type sépiolite, des agents plastifiants, des composés et des résines de type époxy, des agents de stabilisation d'hydrolyse, des lubrifiants, des agents de démoulage, des agents ignifuges, d'autres polymères, des promoteurs d'adhésion, des agents de stabilisation thermique, des agents d'absorption du rayonnement UV, des agents de stabilisation du rayonnement UV, des auxiliaires de transformation, des cires, des agents de stabilisation de la couleur, des pigments, des agents de nucléation, des teintures, des délustrants, des agents anti-adhérants, des agents antistatiques, des azurant optiques, du nitrure de silicium, des agents de piégeage des ions métalliques, des agents antitaches, de l'huile de silicone, des tensioactifs, des antisalissants, des agents de modification de la viscosité, et de l'acide zirconium.

23. Procédé de préparation d'une composition pour nanocomposites de polyester à partir d'un mélange maître, comprenant le compoundage à l'état fondu d'un mélange de: argile de type sépiolite, d'au moins un oligomère de type polyester, et d'au moins un polymère de type polyester afin de produire une composition pour nanocomposites contenant une plus grande concentration d'argile de type sépiolite que souhaitée dans la composition de résine finale; éventuellement, la soumission de ladite composition pour nanocomposites à la polymérisation à l'état solide afin d'augmenter le poids moléculaire du polyester; et en outre le compoundage à l'état fondu de ladite composition pour nanocomposites avec un polymère de type polyester et, éventuellement, des ingrédients supplémentaires.

24. Article mis en forme comprenant la composition pour nanocomposites de polyester produite selon le procédé selon la revendication 1 ou la revendication 23, dans lequel l'article est mis en forme en utilisant au moins un procédé choisi parmi le groupe constitué du moulage par injection, de la (co)extrusion, du moulage par soufflage, du thermoformage, du coulage en solution, de la stratification, et du soufflage de film.

25. Article mis en forme selon la revendication 23, dans lequel ledit article mis en forme est choisi parmi le groupe constitué de:
a. pièces esthétiques choisies parmi le groupe constitué de panneaux de carrosserie automobile, de garde-boues, de carénages frontaux, de capots, de trappes à essence et autres pièces externes; de panneaux intérieurs pour automobile; de dispositifs de fixation d'éclairage automobile; de poignées pour appareils électroménagers, de panneaux de contrôle, de châssis (boîtiers), de tuyaux pour machine à laver et de pièces externes, de panneaux intérieurs ou extérieurs pour réfrigérateur, et de façade ou de panneaux intérieurs pour lave-vaisselle; de logements pour outils électriques; de boîtiers et logements électroniques; de panneaux externes et internes pour des véhicules; de panneaux de décoration intérieure pour des bâtiments; de meubles de bureau et de domicile; de téléphones et d'autres équipements pour téléphone;
b. pièces non esthétiques choisies parmi le groupe constitué des connecteurs électriques, de couvercles de boîtes d'interrupteurs ou de fusibles, de supports de grille de radiateur, de dispositifs de montage de phare, de panneaux de circuits imprimés, de prises, de commutateurs, de composants de clavier, de petits composants de moteur électrique, de chapeau de distributeur, de bobines, de dispositifs de mise en forme de bobinage, de rotors, de bras d'essuie-glace, de dispositifs de montage de phare, d'autres dispositifs de fixation, de maillons de courroie de convoyeur, de tuyau hydraulique, d'attelage de wagon, de fixations de sécurité, de tuyauterie de commande automatique de vide, d'arrêts de porte, d'amortisseurs de wagon de chemin de fer, d'écouteurs; de fibres spéciales, de films, et de feuille; de gainage, d'amortisseurs d'automobile, de diaphragmes pour les wagons de chemin de fer, de tubulure ondulée en plastique, d'organe de traction de chemin de fer, de rubans de commande électrique des vitres, de capuchon CVJ, d'équipement récréatifs pour les pieds, de caoutchoucs conducteurs, d'enrobages de câble, de dispositifs de gestion d'énergie, de cordons de combinés téléphoniques, de patins de compression de ressort, d'attaches-fils, d'étuis d'arme à feu, de courroies de commande, d'inserts pour pneu à affaissement limité et de films médicaux;
c. emballages choisis parmi le groupe constitué du film d'emballage, de doublures, de sacs rétractables, de film plastique, de plateaux d'aliment congelé, d'autres plateaux, d'assemblages plateau/récipient, de bouchons amovibles et non amovibles, de couvercles, de goulots de bouteille pour boissons, de cannettes, de boîtes, de bouteilles, de flacons, de sacs, d'emballages pour cosmétiques, et de tubes à extrémités fermées; et
d. monofilaments, fil à filaments multiples, les cannes à pêche, les soies de brosse à dents, les soies de pinceau, les courroies industrielles et les vêtements pour machine de production de papier comprenant les textiles tissés produits à partir de monofilaments, câbles pour pneumatiques, les composites, les courroies, les textiles, les caoutchoucs renforcés, et textiles industriels de haute résistance.
